# EUROPEAN PATENT SPECIFICATION

(11) **EP 4 564 337 B1**
(45) Date of publication and mention of the grant of the patent: **22.04.2026**
(21) Application number: 23845103.3
(22) Date of filing: 07.06.2023
(51) Int. Cl.: G09F 9/30, G06F 1/16, H04M 1/02

(54) **SUPPORT APPARATUS, HOUSING, AND ELECTRONIC DEVICE**
TRÄGERVORRICHTUNG, GEHÄUSE UND ELEKTRONISCHE VORRICHTUNG
APPAREIL DE SUPPORT, BOÎTIER ET DISPOSITIF ÉLECTRONIQUE

(30) Priority: 27.07.2022 CN 202210893958
(43) Date of publication of application: 04.06.2025
(73) Proprietor: GUANGDONG OPPO MOBILE TELECOMMUNICATIONS CORP., LTD., Dongguan, Guangdong 523860 (CN)
(72) Inventor: YIN, Bin, Dongguan, Guangdong 523860 (CN); TANG, Xiaoqiang, Dongguan, Guangdong 523860 (CN); HAN, Zhongkai, Dongguan, Guangdong 523860 (CN); CHEN, Yongliang, Dongguan, Guangdong 523860 (CN); ZENG, Da, Dongguan, Guangdong 523860 (CN); MA, Qiang, Dongguan, Guangdong 523860 (CN)
(74) Representative: Novagraaf Technologies
(86) International application number: PCT/CN2023/098769
(87) International publication number: WO 2024/021890

(56) References cited:
- EP-A1- 3 869 296
- EP-B1- 2 728 434
- CN-A- 113 516 920
- CN-A- 113 949 760
- CN-A- 114 546 037
- CN-A- 114 697 431
- CN-U- 213 461 837
- KR-A- 20090 061 546
- US-A1- 2020 413 555

## Description

### TECHNICAL FIELD

The present disclosure relates to the technical field of electronic devices, in particular to a support apparatus for supporting a flexible screen, a housing assembly arranged with the support apparatus, and an electronic device arranged with the housing assembly.

### BACKGROUND

With the development and application of flexible screens, there have already been rollable screen mobile phones in the related art. The rollable screen mobile phone includes a support member to support the flexible screen, and the flexible screen is fixedly connected to the support member to form a whole, where the size of the display screen is changed by rolling the flexible screen. However, the support member in the related art needs to rely on the flexible screen to transmit force during the sliding and rolling process, in order to achieve simultaneous unfolding or rolling of the support member and the flexible screen. Therefore, the flexible screen is subject to greater force during the unfolding or rolling process and is thus prone to damages. EP Patent No. EP2728434B1 is related to a portable electronic device. US Patent No. US20200413555A1 is related to a rollable structure and an electronic device using same. EP Patent No. EP3869296A1 is related to a mobile terminal including a first frame, a second frame, a slide frame, a flexible display, and a rolling plate. CN Patent No. CN114546037A is related to an electronic device including a flexible member, a housing assembly and a sliding cover assembly.

### SUMMARY OF THE DISCLOSURE

The present disclosure provides a support apparatus, a housing assembly arranged with the support apparatus, and an electronic device arranged with the housing assembly, as set out in the appended set of claims.

### BRIEF DESCRIPTION OF THE DRAWINGS

In order to more clearly illustrate the technical solution in the embodiments of the present disclosure, the following is a brief description of the drawings needed to be used in the description of the embodiments. Obviously, the drawings described below are only some embodiments of the present disclosure. For those skilled in the art, without the expenditure of creative labor, other drawings can be obtained based on these drawings.
FIG. 1 is a perspective structural schematic view of an electronic device according to some embodiments of the present disclosure.
FIG. 2 is a disassembled perspective schematic view of the structure of the electronic device in FIG. 1.
FIG. 3 is a further disassembled schematic view of the electronic device in FIG. 2.
FIG. 4 is a schematic view of the front structure of the electronic device in FIG. 1.
FIG. 5 is a cross-sectional view along line V-V in FIG. 4.
FIG. 6 is an enlarged view of a support apparatus in FIG. 3.
FIG. 7 is a perspective structural schematic view of a first support rod in FIG. 6.
FIG. 8 is a perspective structural schematic view of the first support rod in FIG. 7 at another viewing angle.
FIG. 9 is a disassembled perspective schematic view of the structure of the first support rod in FIG. 7.
FIG. 10 is a structural schematic view of a side surface of the first support rod in FIG. 7.
FIG. 11 is an enlarged view of part XI in FIG. 7.
FIG. 12 is an enlarged view of part XII in FIG. 8.
FIG. 13 is an enlarged view of part XIII in FIG. 9.
FIG. 14 is an enlarged view of part XIV in FIG. 10.
FIG. 15 is a structural schematic view of an end surface of the first support rod in FIG. 7.
FIG. 16 is a schematic view of an assembly process of two adjacent first support rods in FIG. 6.
FIG. 17 is a perspective structural schematic view of the two first support rods in FIG. 16.
FIG. 18 is a perspective structural schematic view of a connected state of two first support rods in FIG. 6.
FIG. 19 is a perspective structural schematic view of the two first support rods in FIG. 18 at another viewing angle.
FIG. 20 is an enlarged view of part XX in FIG. 19.
FIG. 21 is a structural schematic view of an end of the two first support rods in FIG. 19.
FIG. 22 is a perspective structural schematic view of the support apparatus in FIG. 6 after flattening.
FIG. 23 is a perspective structural schematic view of the support apparatus in FIG. 22 at another viewing angle.
FIG. 24 is a structural schematic view of an end surface of the support apparatus in FIG. 22.
FIG. 25 is an enlarged view of part XXV in FIG. 23.
FIG. 26 is an enlarged view of part XXVI in FIG. 23.
FIG. 27 is a perspective structural schematic view of a bent state of two adjacent first support rods in FIG. 6.
FIG. 28 is a perspective structural schematic view of the two first support rods in FIG. 27 at another viewing angle.
FIG. 29 is a structural schematic view of an end surface of the two first support rods in FIG. 27.
FIG. 30 is an enlarged view of part XXX in FIG. 28.
FIG. 31 is a perspective structural schematic view of the support apparatus in FIG. 6 at another viewing angle.
FIG. 32 is an enlarged view of part XXXII in FIG. 31.
FIG. 33 is a structural schematic view of an end surface of the support apparatus in FIG. 31.
FIG. 34 is a perspective structural schematic view of the electronic device in FIG. 1 in a contracted state.
FIG. 35 is a perspective exploded schematic view of the structure of the electronic device in FIG. 34.
FIG. 36 is a perspective structural schematic view of the support apparatus in FIG. 35 at another viewing angle.
FIG. 37 is an enlarged view of part XXXVII in FIG. 36.
FIG. 38 is a structural schematic view of an end surface of the support apparatus in FIG. 36.
FIG. 39 is a schematic view of the front structure of the electronic device in FIG. 34.
FIG. 40 is a cross-sectional view along the line XL-XL in FIG. 39.
FIG. 41 is a perspective schematic view of a support apparatus according to other embodiments of the present disclosure.
FIG. 42 is a perspective schematic view of a support apparatus according to further other embodiments of the present disclosure.

### Reference numerals:

100, electronic device; 20, housing assembly; 22, support apparatus; 220, first support rod; 221, first rod body; 2211, front surface; 2213, back surface; 2215, side surface; 2216, end surface; 2217, dispensing groove; 2218, stop portion; 2210, avoidance opening; 222, rolling member; 223, first guide bend portion; 2230, first curved surface; 2231, first end; 2233, first connecting end; 2235, curved segment; 224, first stop portion; 2241, first stop surface; 2243, second stop surface; 227, second stop portion; 2271, third stop surface; 2273, fourth stop surface; 225, second guide bend portion; 2250, second curved surface; 2251, second end; 2253, second connecting end; 2255, connecting segment; 226, connecting portion; 228, support portion; 2280, containment groove; 2282, sliding guide space; 2283, positioning member; 229, end fitting; 2291, connecting plate; 2293, support plate; 2295, sliding guide post; 24, first housing; 241, first top wall; 243, first bottom wall; 245, first side wall; 246, first end wall; 247, first storage space; 2410, positioning groove; 2411, sliding guide slot; 2413, connecting slot; 2415, guide slot; 26, second housing; 260, guide rail; 2601, straight rail; 2603, curved rail; 262, sliding frame; 2621, second top wall; 2623, second bottom wall; 2625, second side wall; 2626, second end wall; 2627, second storage space; 2622, avoidance slot; 2624, sliding guide rod; 2628, slider; 2629, connecting strip; 265, blocking member; 2651, blocking piece; 2653, U-shaped groove; 2655, through hole; 2656, snap-in block; 267, end cover; 2671, cover plate; 2673, connecting plate; 2674, storage space; 2676, positioning hole; 50, flexible screen; 52, fixed area; 521, positioning strip; 54, sliding and rolling area; 271, sliding guide rail; 273, sliding guide block.

### DETAILED DESCRIPTION

The following will clearly and completely describe the technical solution in the embodiments of the present disclosure in conjunction with the accompanying drawings in the embodiments of the present disclosure. Obviously, the embodiments described are only a portion of the embodiments of the present disclosure, not all of the embodiments. Based on the embodiments in the present disclosure, all other embodiments obtained by those skilled in the art without creative effort are within the scope of the present disclosure.

In addition, the description of the following embodiments refers to the additional drawings to illustrate specific embodiments that can be implemented of the present disclosure. The directional terms mentioned in the present disclosure, such as "top", "bottom", "front", "rear", "left", "right", "inside", "outside", and "side", etc., are only intended for reference to the orientation of the additional drawings. Therefore, the directional terms are intended to better and more clearly illustrate and understand the present disclosure, and are not intended to indicate or imply that the referred device or element must have a specific orientation or be constructed and operated in a specific orientation. Therefore, they should not be understood as limitations of the present disclosure. The term of "natural state" refers to the state of a device or element without an external force, such as tension or pressure.

In the description of the present disclosure, it is stated that unless otherwise expressly provided and limited, the terms "installed", "connected", "coupled", and "arranged", etc. should be understood in a broad sense. For example, it may be a fixed connection, or a detachable connection, or a one-piece connection; it may be a mechanical connection; it may be a direct connection, or an indirect connection through an intermediate medium, or it may be a connection within two elements. For those skilled in the art, the specific meaning of the above terms in the present disclosure can be understood in the specific context.

In a first aspect, the present disclosure provides a support apparatus, including a plurality of first support rods that are rotatably connected to each other along a first direction; wherein each of the plurality of first support rods includes a first rod body, a first guide bend portion, and a second guide bend portion; the first rod body includes two opposite sides along the first direction, and each of the two opposite sides of the first rod body is arranged with the first guide bend portion and the second guide bend portion; for each adjacent two first support rods of the plurality of first support rods, the first guide bend portion on a first side of one of the adjacent two first support rods rotatably abuts against the second guide bend portion on a second side of the other of the adjacent two first support rods, and the second guide bend portion on the first side of the one of the adjacent two first support rods rotatably abuts against the first guide bend portion on the second side of the other of the adjacent two first support rods.

In some embodiments, the first guide bend portion includes a first curved surface, the second guide bend portion includes a second curved surface, and the first curved surface and the second curved surface on a same side of each first support rod have a coaxial line; the first curved surface on the first side of one of the adjacent two first support rods rotatably abuts against the second curved surface on the second side of the other of the adjacent two first support rods, and the second curved surface on the first side of one of the adjacent two first support rods rotatably abuts against the first curved surface on the second side of the other of the adjacent two first support rods.

In some embodiments, the first guide bend portion and the second guide bend portion on a same side of each first support rod are spaced apart along a length direction of the first rod body of the first support rod; the first guide bend portion on one of the two opposite sides of the first support rod faces the second guide bend portion on the other of the two opposite sides of the first support rod along the first direction, the length direction of the first rod body being perpendicular to the first direction.

In some embodiments, the first guide bend portion further includes a first curved strip arranged on a back surface of the first rod body, and the second guide bend portion further includes a second curved strip arranged on a back surface of the first rod body; the first curved surface is arranged on a surface of the first rod body facing the first curved strip, and the second curved surface is arranged on a surface of the second curved strip away from the first rod body.

In some embodiments, the first support rod further includes a first stop portion connected to the first guide bend portion and a second stop portion connected to the second guide bend portion; in a case where the adjacent two first support rods are flattened, the first stop portion of one of the adjacent two first support rods and the second stop portion of the other of the adjacent two first support rods abut against each other; in a case where the adjacent two first support rods are bent relative to each other, the first stop portion of one of the adjacent two first support rods and the second stop portion of the other of the adjacent two first support rods move away from each other.

In some embodiments, the first stop portion is arranged on an end of the first guide bend portion away from the first rod body, the second stop portion is arranged on an end of the second guide bend portion away from the first rod body, and the first stop portion on a side of the first rod body directly faces the second stop portion on an opposite side of the first rod body in the first direction.

In some embodiments, the first stop portion on the side of the first rod body includes a first stop surface facing the second stop portion on the opposite side of the first rod body, and a second stop surface facing the first rod body; the second stop portion on the side of the first rod body includes a third stop surface facing the first stop portion on the opposite side of the first rod body, and a fourth stop surface facing the first stop portion along a length direction of the first rod body; in a case where the adjacent two first support rods are flattened, the first stop surface of one of the adjacent two first support rods and the third stop surface of the other of the adjacent two first support rods abut against each other, the second stop surface of the one of the adjacent two first support rods and a corresponding second curved surface of the other of the adjacent two first support rods abut against each other, and the fourth stop surface of the other of the adjacent two first support rods and a corresponding first guide bend portion of the one of the adjacent two first support rods abut against each other.

In some embodiments, the first stop portion extends from the first guide bend portion along an axial direction of the first curved surface towards the second guide bend portion on a same side of the first rod body as the first stop portion; the second stop portion protrudes from an end of the second curved surface of the second guide bend portion close to the first guide bend portion on a same side of the first rod body as the second stop portion.

In some embodiments, a plane where axis lines of two of the first curved surfaces on the two opposite sides of the first support rod lie is coplanar with a front surface of the first rod body; or, a plane where axis lines of two of the second curved surfaces on the two opposite sides of the first support rod lie is coplanar with a front surface of the first rod body.

In some embodiments, on each of the two opposite sides of each first support rod, the first guide bend portion includes two first guide bend portions and the two guide bend portion includes two second guide bend portions; the two first guide bend portions are arranged at two opposite ends of the first rod body along a length direction of the first rod body, and the two second guide bend portions are arranged at the two opposite ends of the first rod body along the length direction of the first rod body; on each of the two opposite ends of the first rod body, a corresponding one of the two first guide bend portions directly faces a corresponding one of the two second guide bend portions; axis lines of two of the first curved surfaces and axis lines of two of the second curved surfaces on a same side of the first support rod are co-linear.

In some embodiments, the first support rod further includes a connecting portion connected to a back surface of the first rod body, and a support portion connected to an end of the connecting portion away from the first guide bend portion; the support portion, the connecting portion, and the first rod body encloses to define a sliding guide space.

In some examples useful for understanding the invention, the first support rod further includes a rolling member, and the support portion defines a containment groove, an opening of the containment groove being communicated to the sliding guide space; the rolling member is placed in the containment groove in a rollable manner, and part of an outer surface of the rolling member is exposed from the containment groove.

In some embodiments, along a length direction of the first rod body, a stop portion is arranged on each of two opposite ends of a front surface of the first rod body, and a space between two of the stop portions on the opposite ends is configured to receive a flexible screen.

In some embodiments, the support apparatus further includes a second support rod and a third support rod; the second support rod is connected to one of two outermost first support rods among the plurality of first support rods; the second support rod is rotatably connected to the one of two outermost first support rods by a cooperation of the first guide bend portion and the second guide bend portion; the third support rod is connected to the other of two outermost first support rods, among the plurality of first support rods, away from the second support rod; the third support rod is rotatably connected to the other of two outermost first support rods by a cooperation of the first guide bend portion and the second guide bend portion.

In a second aspect, the present disclosure provides a housing assembly, including a support apparatus, a first housing, and a second housing; wherein the first housing is slidably connected to the second housing, and the support apparatus is slidably wound around the second housing; a side of the support apparatus is fixedly connected to the first housing; in a case where the first housing slides relative to the second housing, the support apparatus slides and rolls around the second housing. The support apparatus includes a plurality of first support rods that are rotatably connected to each other along a first direction; wherein each of the plurality of first support rods includes a first rod body, a first guide bend portion, and a second guide bend portion; the first rod body includes two opposite sides along the first direction, and each of the two opposite sides of the first rod body is arranged with the first guide bend portion and the second guide bend portion; for each adjacent two first support rods of the plurality of first support rods, the first guide bend portion on a first side of one of the adjacent two first support rods rotatably abuts against the second guide bend portion on a second side of the other of the adjacent two first support rods, and the second guide bend portion on the first side of the one of the adjacent two first support rods rotatably abuts against the first guide bend portion on the second side of the other of the adjacent two first support rods.

In some examples useful for understanding the invention, the second housing is arranged with a guide rail, and the guide rail includes two straight rails spaced apart relative to each other and a curved rail connected between the two straight rails; the curved rail is disposed on an end away from the first housing, and the support apparatus is slidably wound around the guide rail.

In some examples useful for understanding the invention, at least a part of the guide rail is slidably received in the sliding guide space, and the rolling member of the first support rod is in rolling contact with the guide rail.

In some examples useful for understanding the invention, the second housing includes a sliding frame, and a blocking member connected to an end of the sliding frame; the guide rail is arranged on a side of the blocking member facing the sliding frame; the blocking member is configured to block the first guide bend portion and the second guide bend portion of the first support rod.

In a third aspect, the present disclosure provides an electronic device, including a housing assembly and a flexible screen. The housing assembly includes a support apparatus, a first housing, and a second housing; wherein the first housing is slidably connected to the second housing, and the support apparatus is slidably wound around the second housing; a side of the support apparatus is fixedly connected to the first housing; in a case where the first housing slides relative to the second housing, the support apparatus slides and rolls around the second housing. The support apparatus includes a plurality of first support rods that are rotatably connected to each other along a first direction; wherein each of the plurality of first support rods includes a first rod body, a first guide bend portion, and a second guide bend portion; the first rod body includes two opposite sides along the first direction, and each of the two opposite sides of the first rod body is arranged with the first guide bend portion and the second guide bend portion; for each adjacent two first support rods of the plurality of first support rods, the first guide bend portion on a first side of one of the adjacent two first support rods rotatably abuts against the second guide bend portion on a second side of the other of the adjacent two first support rods, and the second guide bend portion on the first side of the one of the adjacent two first support rods rotatably abuts against the first guide bend portion on the second side of the other of the adjacent two first support rods. The flexible screen includes a fixed area and a sliding and rolling area; the fixed area is fixed to the first housing of the housing assembly, and the sliding and rolling area is affixed to a front surface of the support apparatus of the housing assembly.

In some examples useful for understanding the invention, the sliding and rolling area of the flexible screen is connected to the support apparatus via an adhesive layer, and a rotation axis line between adjacent two first support rods, among the plurality of first support rods, of the support apparatus is disposed in the adhesive layer.

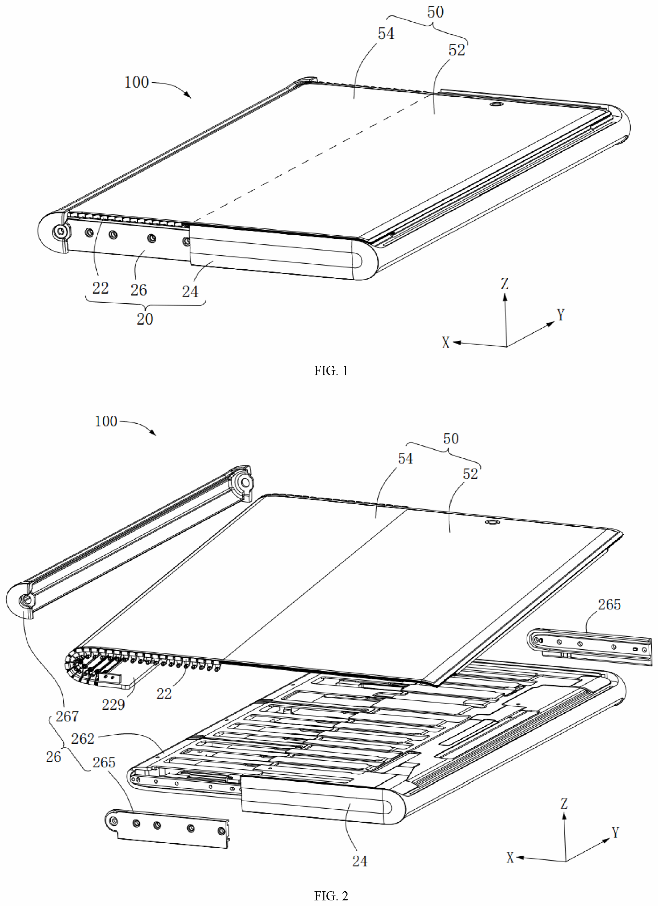

Referring to FIGS. 1-6, in some embodiments of the present disclosure, the electronic device 100 may be mobile phones, tablet computers, personal computers, laptops, monitors, in-vehicle camera modules, cameras, smart watches, smart bracelets, smart glasses, portable multimedia players, and mobile medical devices, etc. In the present embodiments, a mobile phone is taken as an example for specific explanation. The electronic device 100 includes a housing assembly 20 and a flexible screen 50. The housing assembly 20 includes a support apparatus 22, a first housing 24 and a second housing 26. The first housing 24 and the second housing 26 are slidably connected to each other, such that the first housing 24 and the second housing 26 can contract or extend with each other. The electronic device 100 further includes electronic components such as a motherboard and a power supply disposed in the housing assembly 20. The motherboard is electrically connected to the flexible screen 50 and the power supply, and the power supply is configured to supply power to the flexible screen 50 and the motherboard. The flexible screen 50 includes a fixed area 52 and a sliding and rolling area 54 disposed on a side of the fixed area 52. The fixed area 52 is fixed to a front surface of the first housing 24, and the sliding and rolling area 54 is affixed to a surface of the support apparatus 22 away from the second housing 26, i.e., the sliding and rolling area 54 is affixed to a front surface of the support apparatus 22 of the housing assembly 20. A positioning strip 521 is arranged on a side of the fixed area 52 away from the sliding and rolling area 54. When the first housing 24 slides relative to the second housing 26, the support apparatus 22 slides and rolls around the second housing 26, and the sliding and rolling area 54 slides and rolls around the second housing 26 following the support apparatus 22. Specifically, when the second housing 26 extends in a first direction relative to the first housing 24, i.e., the second housing 26 moves away from the first housing 24 along an X-axis direction, the second housing 26 drives the support apparatus 22 to slide relative to the second housing 26 and extend, and the sliding and rolling area 54 extends synchronously with the support apparatus 22, such that the display area of the flexible screen 50 is increased; when the second housing 26 contracts relative to the first housing 24 in a second direction, that is, the second housing 26 moves relative to the first housing 24 in the X-axis direction and moves closer to the first housing 24, the second housing 26 drives the support apparatus 22 to slide relative to the second housing 26 and roll, and the sliding and rolling area 54 rolls synchronously with the support apparatus 22, such that the volume of the housing assembly 20 is reduced. When the sliding and rolling area 54 is extended, the display surface of the flexible screen 50 is increased, which is convenient for the user to use the electronic device; when the sliding and rolling area 54 is rolled up, the volume of the electronic device 100 is reduced, which is convenient for carrying.

In the present disclosure, the front surface refers to a surface oriented in the same direction as a light-emitting surface of the flexible screen 50, and the back surface refers to a surface oriented in the opposite direction of the light-emitting surface of the flexible screen 50. The first direction is opposite to the second direction. The X-axis direction refers to a sliding direction of the second housing 26 relative to the first housing 24, a Z-axis direction refers to a thickness direction of the electronic device 100, and a Y-axis direction refers to a direction that is perpendicular to both the X-axis direction and the Z-axis direction.

As shown in FIGS. 2-3 and 5, the first housing 24 includes a first top wall 241, a first bottom wall 243 opposite the first top wall 241, a first side wall 245 connected to the first top wall 241 and the first bottom wall 243 on the same side, and two first end walls 246 opposite to each other; the first top wall 241, the first bottom wall 243, the first side wall 245, and the two first end walls 246 enclose a first storage space 247; the first storage space 247 is configured to contain components such as the second housing 26, the motherboard, and the power supply. The front surface of the first housing 24 defines a positioning groove 2410, and the fixed area 52 of the flexible screen 50 is positioned in the positioning groove 2410. The first housing 24 further defines multiple sliding guide slots 2411 spaced apart from each other on a bottom surface of the positioning groove 2410 on a side away from the first side wall 245, and the multiple sliding guide slots 2411 are arranged in the Y-axis direction, where each sliding guide slot 2411 is in communication with the positioning groove 2410. Specifically, the multiple sliding guide slots 2411 are disposed on a surface of the first top wall 241 away from the first bottom wall 243 on a side away from the first side wall 245, the multiple sliding guide slots 2411 are distributed in the Y-axis direction, and each sliding guide slot 2411 extends in the X-axis direction. The first side wall 245 defines a connecting slot 2413 near the first top wall 241, the connecting slot 2413 being in communication with the positioning groove 2410, where two opposite ends of the connecting slot 2413 extend in the Y-axis direction to a position close to the two first end walls 246, and the connecting slot 2413 is configured to position the positioning strip 521 of the flexible screen 50. Each of two opposite ends of the first housing 24 defines a guide slot 2415, which extends in the direction of the X-axis to a position close to the first side wall 245, and the second housing 26 is slidably connected to two of the guide slots 2415. In particular, each guide slot 2415 is defined between a corresponding end of the first top wall 241 and a corresponding first end wall 246. In some embodiments, an outer side of the first side wall 245 is configured to be a curved surface.

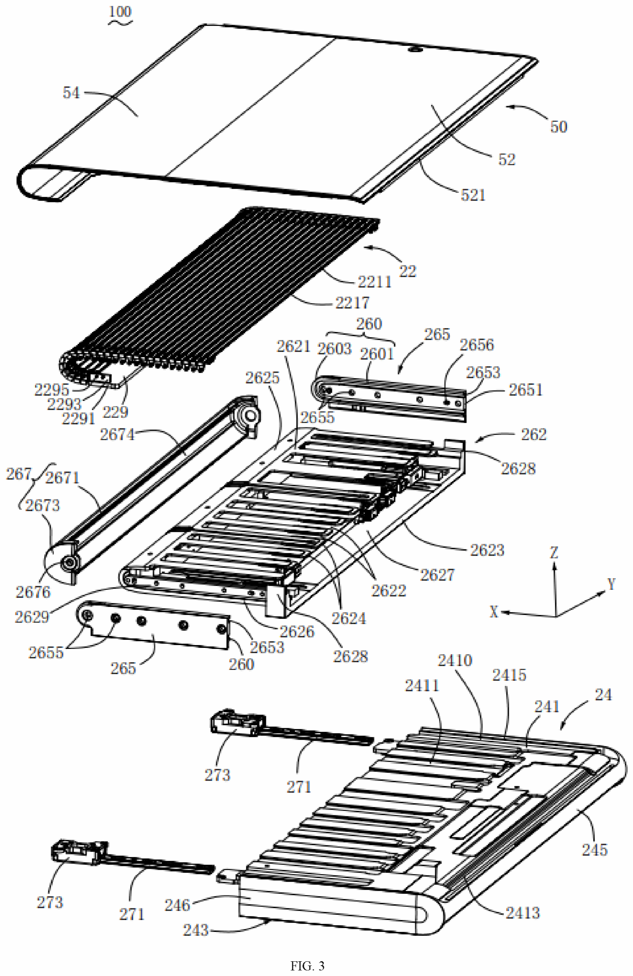

As shown in FIGS. 2 and 3, a side portion of the second housing 26 is arranged with a guide rail 260, and the support apparatus 22 is slidably arranged around the guide rail 260. When the second housing 26 slides relative to the first housing 24, the support apparatus 22 moves around the guide rail 260. In the embodiments, the guide rail 260 is arranged on each of two opposite ends of the second housing 26, and the support apparatus 22 is slidably arranged around the guide rails 260 at the two ends. When the second housing 26 slides relative to the first housing 24, two opposite ends of the support apparatus 22 move synchronously around the two guide rails 260, so as to flatten or roll the support apparatus 22. The second housing 26 includes a sliding frame 262, a blocking member 265 connected to an end of the sliding frame 262, and an end cover 267 connected to an end of the sliding frame 262 away from the first housing 24. The guide rail 260 is arranged on a side of the blocking member 265 facing the sliding frame 262. In some embodiments, the blocking member 265 is connected to each of two opposite ends of the sliding frame 262, and the guide rail 260 is arranged on a side of each blocking member 265 facing the sliding frame 262. In other embodiments, the guide rail 260 is arranged on an end of the sliding frame 262, and specifically, the sliding frame 262 is arranged with two guide rails 260 on the two opposite ends.

As shown in FIG. 3, the sliding frame 262 includes a second top wall 2621, a second bottom wall 2623 opposite the second top wall 2621, a second side wall 2625 connected to the second top wall 2621 and the second bottom wall 2623 on the same side, and two second end walls 2626 opposite to each other; the second top wall 2621, the second bottom wall 2623, the second side wall 2625, and the two second end walls 2626 enclose a second storage space 2627. A front surface of the second housing 26 defines multiple avoidance slots 2622 spaced apart from each other, each avoidance slot 2622 extending in the sliding direction of the second housing 26 relative to the first housing 24, i.e., the avoidance slot 2622 extends in the X-axis direction, and the multiple avoidance slots 2622 are distributed along the Y-axis direction to form multiple sliding guide rods 2624 on the second housing 26. Specifically, the multiple avoidance slots 2622 are disposed on the second top wall 2621, the multiple avoidance slots 2622 are distributed along the Y-axis direction, each avoidance slot 2622 penetrates the second top wall 2621 and an end of the avoidance slot 2622 extends to a position close to the second side wall 2625, and the opposite end of the avoidance slot 2622 penetrates a side of the second top wall 2621 away from the second side wall 2625, thereby forming the multiple sliding guide rods 2624 on the second top wall 2621. The multiple sliding guide rods 2624 are distributed in the Y-axis direction, and the multiple sliding guide rods 2624 correspond to the multiple sliding guide slots 2411 of the first housing 24 in a one-to-one correspondence. An outer side of the second side wall 2625 is configured to be a curved surface, that is, the outer side of the second side wall 2625 away from the first housing 24 is configured to be a curved surface, so as to facilitate the sliding and rolling of the support apparatus 22 around the second housing 26. A slider 2628 is arranged on an end of the second end wall 2626 away from the second side wall 2625, and the slider 2628 is slidably inserted in a corresponding guide slot 2415 of the first housing 24. A connecting strip 2629 is arranged protruding from a middle portion of the second end wall 2626 towards a side away from the second storage space 2627, where the connecting strip 2629 extends in the X-axis direction, and the connecting strip 2629 defines multiple connecting holes and snap-fit holes arranged at intervals. The multiple connecting holes are arranged at intervals along the X-axis direction, and one of the connecting holes is disposed on an end of the connecting strip 2629 close to the second side wall 2625. In some embodiments, an end surface of the connecting strip 2629 close to the second side wall 2625 is arranged with a curved surface to facilitate the sliding and rolling of the support apparatus 22 around the second housing 26.

The blocking member 265 includes a blocking piece 2651, the blocking piece 2651 being a rectangular plate. An end surface of the rectangular plate away from the first housing 24 is configured to be a curved surface, and a side of the blocking piece 2651 facing the sliding frame 262 defines a U-shaped groove 2653. The U-shaped groove 2653 extends along an edge of the blocking piece 2651, and two ends of the U-shaped groove 2653 penetrate an end surface of the blocking piece 2651 away from the curved surface, thereby forming a U-shaped guide rail 260 on the blocking piece 2651. The guide rail 260 includes two straight rails 2601 spaced apart relative to each other and a curved rail 2603 connected between the two straight rails 2601. The curved rail 2603 is disposed on an end away from the first housing 24, and the opposite ends of the curved rail 2603 are respectively connected to the ends of the two straight rails 2601. The curved rail 2603 and the straight rail 2601 smoothly transitions, and the support apparatus 22 is slidably arranged around the guide rail 260. The middle of the blocking member 265 is arranged with multiple spaced-apart through holes 2655 and a snap-in block 2656. The multiple through holes 2655 are arranged along the X-axis direction, and one of the through holes 2655 is close to the curved rail 2603.

The end cover 267 includes a cover plate 2671 and a connecting plate 2673 arranged at each of opposite ends of the cover plate 2671. The cover plate 2671 has a cross-sectional shape of a circle arc. The cover plate 2671 and the two connecting plates 2673 enclose to define a storage space 2674, and the storage space 2674 is configured to receive a part of the support apparatus 22 and flexible screen 50 on a side of the second housing 26 away from the first housing 24 and wound around the second side wall 2625. A positioning hole 2676 is defined on the middle of each of the two connecting plates 2673.

The first housing 24 is slidably connected to the second housing 26 by a sliding guide rail 271 engaging with a sliding guide block 273. The sliding guide rail 271 is arranged on one of the first housing 24 and the second housing 26, and the sliding guide block 273 is arranged in the other of the first housing 24 and the second housing 26. In the illustrated embodiments, two sliding guide rails 271 are arranged in parallel in the first storage space 247 of the first housing 24, and the sliding guide rails 271 extend in the X-axis direction; two sliding guide blocks 273 are arranged at intervals in the second storage space 2627 of the second housing 26. When the first housing 24 is assembled with the second housing 26, the two sliding guide blocks 273 are slidably connected to the two sliding guide rails 271. Specifically, the two sliding guide rails 271 are each connected to the first bottom wall 243 of the first housing 24, and the two sliding guide blocks 273 are each connected to the second bottom wall 2623 of the second housing 26.

In some embodiments, the sliding guide rail 271 is arranged in the second storage space 2627 of the second housing 26 and extends in the X-axis direction, and the sliding guide block 273 is arranged in the first storage space 247 of the first housing 24. When the first housing 24 is assembled with the second housing 26, the sliding guide block 273 is slidably connected to the sliding guide rail 271. In some embodiments, the second housing 26 is arranged with two sliding guide rails 271 arranged parallel to each other on a surface of the second bottom wall 2623 facing the second storage space 2627, and the first housing 24 is arranged with two spaced sliding guide blocks 273 on a surface of the first bottom wall 243 facing the first storage space 247. When the first housing 24 is assembled with the second housing 26, the two sliding guide blocks 273 are respectively slidably connected to the two sliding guide rails 271.

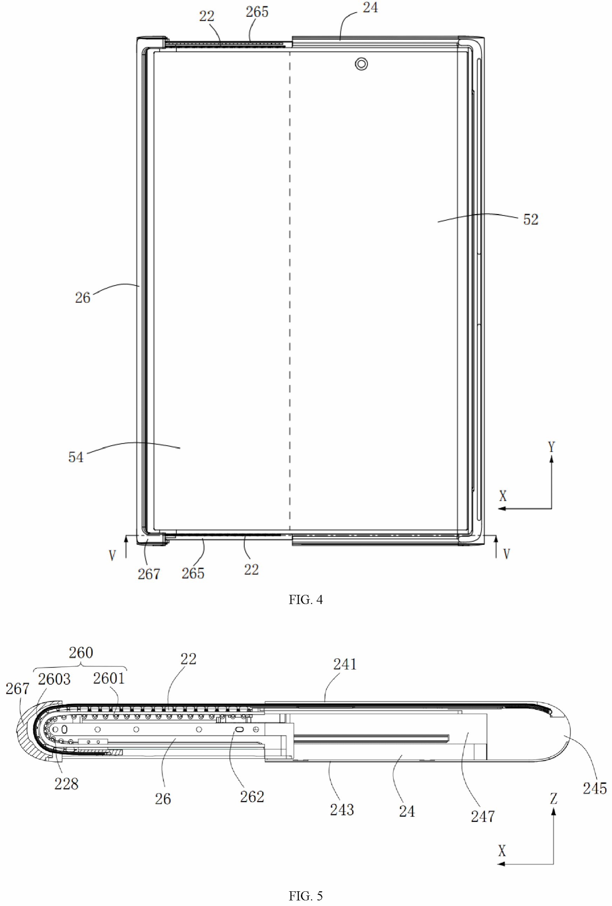

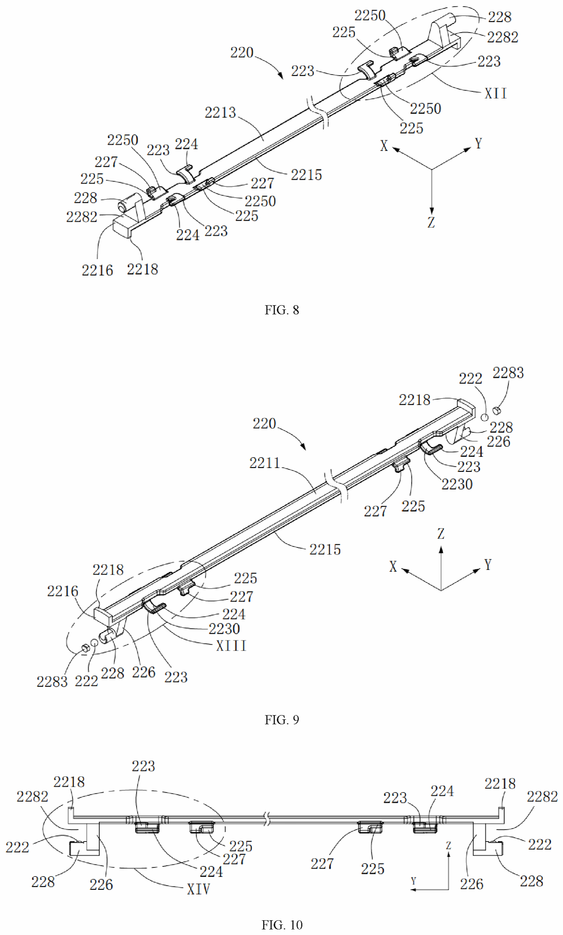

As shown in FIGS. 5-8, the support apparatus 22 includes multiple first support rods 220 that are rotatably connected to each other along the first direction (i.e., the X-axis direction), and each two adjacent first support rods 220 can be unfolded (flattened) or bent with respect to each other. Each first support rod 220 includes a first rod body 221, a first guide bend portion 223, and a second guide bend portion 225. The first rod body 221 includes opposite sides along the first direction (i.e., the X-axis direction), and each side of the first rod body 221 is arranged with the first guide bend portion 223 and the second guide bend portion 225. The first guide bend portion 223 and the second guide bend portion 225 on a same side of one first support rod 220 respectively rotatably abut against the second guide bend portion 225 and the first folding guide part 223 on a same side of another adjacent first support rod 220. That is, the first guide bend portion 223 on a first side of one first support rod 220 rotatably abuts against the second guide bend portion 225 on a second side of the other first support rod 220, and the second guide bend portion 225 on the first side of the one first support rod 220 rotatably abuts against the first guide bend portion 223 on the second side of the other first support rod 22. When the two adjacent first support rods 220 are rotated relative to each other, the first guide bend portions 223 of the two adjacent first support rods 220 and the corresponding second guide bend portions 225 rotate relative to each other, such that the two adjacent first support rods 220 can transfer forces to each other, so as to bend or flatten the support apparatus 22. The support apparatus 22 is slidably arranged around the second housing 26, and a side of the support apparatus 22 is fixedly connected to the first housing 24. Specifically, the first support rod 220 of the support apparatus 22 adjacent to the first housing 24 is connected to the first housing 24.

In the electronic device 100 of the present disclosure, the second housing 26 is slidably connected to the first housing 24, the support apparatus 22 is slidably wound around the second housing 26, and the first support rod 220 on a side of the support apparatus 22 is connected to the first housing 24. The fixed area 52 of the flexible screen 50 is positioned on the front surface of the first housing 24, and the sliding and rolling area 54 of the flexible screen 50 is affixed to the surface of the support apparatus 22 away from the first housing 24. When the second housing 26 slides relative to the first housing 24 to extend or contract, the second housing 26 drives the support apparatus 22 to slide relative to the second housing 26 to unfold or roll, and the sliding and rolling area 54 unfolds or rolls up with the support apparatus 22. Since the sliding and rolling area 54 of the flexible screen 50 is cooperated with the second housing 26 via the support apparatus 22, the two adjacent first supporting rods 220 in the support apparatus 22 are rotatably connected via the cooperation between first guide bend portion 223 and the second guide bend portion 225, and during the adjacent two first support rods 220 rotate relative to each other, the first guide bend portion 223 slides against the second guide bend portion 225 to impart a force between the two first support rods 220, such that the support apparatus 22 can move along a rolling trajectory. In other words, the support apparatus 22 can slide around the second housing 26 to unfold or roll without being attached to the flexible screen 50, such that the sliding and rolling area 54 of the flexible screen 50 is subjected to less force during the process of unfolding or rolling along the support apparatus 22, which may prevent damage to the flexible screen 50.

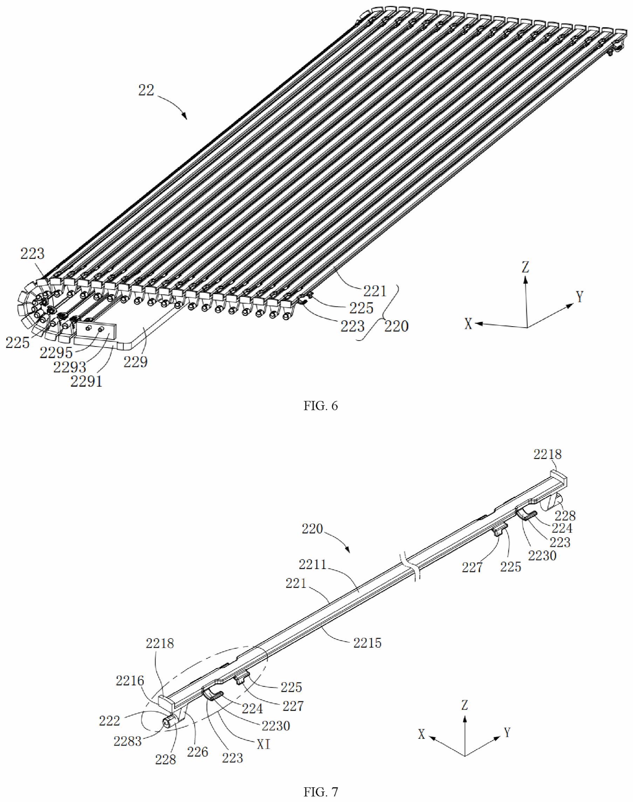

Further referring to FIGS. 6-15, the first rod body 221 includes a front surface 2211, a back surface 2213 back from the front surface 2211, two side surfaces 2215 opposite to each other, and two end surfaces 2216 opposite to each other. The first guide bend portion 223 and the second guide bend portion 225 are arranged on each of the opposite sides of the first rod body 221. In some embodiments, the front surface 2211 is curved on its two opposite sides. In other embodiments, the front surface 2211 may define multiple dispensing grooves arranged along the Y-axis direction, and the dispensing grooves are configured to contain an adhesive, so as to facilitate the bonding of the flexible screen 50 to the first support rod 220. Along the length direction of the first rod body 221, a stop portion 2218 is arranged on each of two opposite ends of the front surface 2211 of the first rod body 221. The space between the two stop portions 2218 on the opposite ends is configured to receive the flexible screen 50, i.e., the flexible screen 50 is attached to the front surface 2211 and is disposed between the two stop portions 2218. Specifically, the two stop portions 2218 are stop tabs protruding from the front surface 2211. A side wall of the first rod body 221 defines an avoidance opening 2210 at a position corresponding to the first guide bend portion 223, and the avoidance opening 2210 is configured to receive the corresponding second guide bend portion 225.

The first guide bend portion 223 includes a first curved surface 2230, the second guide bend portion 225 includes a second curved surface 2250, and the first support rod 220 has a coaxial line between the first curved surface 2230 and the second curved surface 2250 on the same side. The first curved surface 2230 on a first side of one first support rod 220 rotatably abuts against the second curved surface 2250 on a second side of another adjacent first support rod 220, and the second curved surface 2250 on the first side of one first support rod 220 rotatably abuts against the first curved surface 2230 on the second side of another adjacent first support rod 220. The first curved surface 2230 and the second curved surface 2250, that abut against each other, share a same axial line. When the first guide bend portion 223 of one first support rod 220 abuts against the second guide bend portion 225 of another adjacent first support rod 220, the first guide bend portion 223 is connected to its corresponding second guide bend portion 225 in a lapping manner, where the first curved surface 2230 and the second curved surface 2250 on one side of the first support rod 220 respectively abut against the second curved surface 2250 and the first curved surface 2230 on one side of the other first support rod 220. In this case, the first curved surface 2230 and the corresponding second curved surface 2250 are coaxial, and there is a mutual buttress force between the first curved surface 2230 and the corresponding second curved surface 2250, such that the two adjacent first support rods 220 can be flattened or bent relative to each other.

The first support rod 220 is arranged with the first guide bend portion 223 and the second guide bend portion 225 on each of the both opposite sides. The first guide bend portion 223 and the second guide bend portion 225 on the same side of the first support rod 220 are spaced apart along the length direction. The first guide bend portion 223 on one side of the first support rod 220 faces the second guide bend portion 225 on the opposite side of the first support rod 220 along the first direction (i.e., the X-axis direction), where the length direction of the first rod body 221 is perpendicular to the first direction. Specifically, the first support rod 220 is arranged with at least one first guide bend portion 223 and at least one second guide bend portion 225 on each of the both opposite sides, and the first guide bend portion 223 and the second guide bend portion 225 on the same side of the first support rod 220 are spaced apart. The two first guide bend portions 223 on opposite sides of the first support rod 220 are misaligned from each other in the Y-axis direction, and the two second guide bend portions 225 on opposite sides of the first support rod 220 are misaligned from each other in the Y-axis direction. A first guide bend portion 223 and a second guide bend portion 225 on the same side of the first support rod 220 forms a connection unit, and the first support rod 220 has at least one connection unit on each side. The adjacent two first support rods 220 are rotatably connected by at least one pair of the connection units, i.e., the first guide bend portion 223 of the connection unit on a side of one of the adj acent two first support rods 220 rotatably abuts against the second guide bend portion 225 of the connection unit on a side of the other first support rod 220, and the second guide bend part 225 of the connection unit on the side of the one first support rod 220 rotatably abuts against the first guide bend part 223 of the connection unit on the side of the other first support rod 220.

The first guide bend portion 223 includes a first curved strip arranged on the back surface 2213 of the first rod body 221, and the second guide bend portion 225 includes a second curved strip arranged on the back surface 2213 of the first rod body 221. The first curved surface 2230 is arranged on the surface of the first rod body 221 facing the first curved strip, and the second curved surface 2250 is arranged on the surface of the second curved strip away from the first rod body 221. When the first curved surface 2230 and the corresponding second curved surface 2250, of two adjacent first supporting rods 220, rotatably abut against each other, the second guide bend portion 225 is closer to the first rod body 221 than the first guide bend portion 223. The first curved strip and the second curved strip on the same side of the first rod body 221 extend to the same side of the first rod body 221. Specifically, the first guide bend portion 223 bends from one side surface 2215 of the first rod body 221 adjacent to the first guide bend portion 223 and extends towards the other side surface 2215 and away from the back surface 2213, and the first curved surface 2230 is arranged on a side of the first curved strip facing the back surface 2213. The second guide bend portion 225 bends from one side surface 2215 of the first rod body 221 adjacent to the second guide bend portion 225 and extends towards the other side surface 2215 and away from the back surface 2213, and the second curved surface 2250 is arranged on a side of the second curved strip away from the back surface 2213. In some embodiments, the first curved surface 2230 and the second curved surface 2250 on the same side of the first rod body 221 share a same curved-surface form. Specifically, the first guide bend portion 223 includes a first end 2231 and a first connecting end 2233 that are disposed on opposite ends of the first guide bend portion 223, the first connecting end 2233 being configured to connect the first rod body 221, and the first end 2231 being further away from the first rod body 221 compared to the first connecting end 2233. The second guide bend portion 225 includes a second end 2251 and a second connecting end 2253 disposed on opposite ends of the second guide bend portion 225, the second connecting end 2253 being configured to connect the first rod body 221, and the second end 2251 being further away from the first rod body 221 compared to the second connecting end 2253. In the present embodiments, the surface of the first guide bend portion 223 facing the first rod body 221 and the surface of the first guide bend portion 223 away from the first rod body 221 are each arranged with a curved surface, and the two curved surfaces are parallel. The curved surface of the surface facing the first rod body 221 is the first curved surface 2230. The surface of the second guide bend portion 225 away from the first rod body 221 and the surface of the second guide bend portion 225 facing the first rod body 221 are each arranged with a curved surface, and the curved surface of the surface facing the first rod body 221 is the second curved surface 2250. In other embodiments, the surface of the first guide bend portion 223 away from the first rod body 221 may not be arranged with a curved surface, and the surface of the second guide bend portion 225 facing the first rod body 221 may not be arranged with a curved surface.

Further referring to FIGS. 7-14, the first support rod 220 further includes a first stop portion 224 connected to the first guide bend portion 223 and a second stop portion 227 connected to the second guide bend portion 225, both the first stop portion 224 and the second stop portion 227 being away from the first rod body 221. In some embodiments, the first stop portion 224 is arranged on an end of the first guide bend portion 223 away from the first rod body 221, the second stop portion 227 is arranged on an end of the second guide bend portion 225 away from the first rod body 221, and the first stop portion 224 on a side of the first rod body 221 is arranged facing the second stop portion 227 on the opposite side of the first rod body 221 in the first direction (i.e., the X-axis direction), i.e., the first stop portion 224 and the second stop portion 227 are arranged facing each other in the X-axis direction. Specifically, the first stop portion 224 is a convex strip on the first end 2231 of the first guide bend portion 223, and extends from the first guide bend portion 223 along an axial direction of the first curved surface 2230 (i.e., along the Y-axis) towards the second guide bend portion 225 on the same side of the first rod body 221. The second stop portion 227 is a convex block on the second end 2251 of the second guide bend portion 225, and protrudes from an end of the second curved surface 2250 of the second guide bend portion 225 close to the first guide bend portion 223 on the same side of the first rod body 221. The first stop portion 224 on one side of the first rod body 221 includes a first stop surface 2241 facing the second stop portion 227 on the opposite side of the first rod body 221, and a second stop surface 2243 facing the first rod body 221. The second stop portion 227 is a stop plate disposed on a side of the connecting portion 226 close to the middle of the first rod body 221, and the stop plate extends from a side close to the first rod body 221 towards the adjacent second guide bend portion 225 (i.e., along the Z-axis direction). The second stop portion 227 on a side of the first rod body 221 includes a third stop surface 2271 facing the first stop portion 224 on the opposite side of the first rod body 221, and a fourth stop surface 2273 facing the first stop portion 224 along the length direction of the first rod body 221. That is, the fourth stop surface 2273 on the second stop portion 227 on a side of the first rod body 221 faces an opposite direction from the adjacent first stop portion 224 on the same side of the first rod body 221. When two first support rods 220 connected to each other are flattened, the first stop surface 2241 of one first support rod 220 and the third stop surface 2271 of the other first support rod 220 abut against each other, preventing the two first support rods 220 from folding back. When the two first support rods 220 are bent relative to each other, the first stop surface 2241 of one first support rod 220 and the third stop surface 2271 of the other first support rod 220 move away from each other, so as not to hinder the mutual bending of the two first support rods 220.

In other embodiments, the first stop portion on the first guide bend portion 223 and the second stop portion on the second guide bend portion 225 on the same side of the first support rod 220 can be interchanged, i.e. a second stop portion is arranged on the first guide bend portion 223 on each side of the first support rod 220, and a first stop portion is arranged on the second guide bend portion 225 on each side of the first support rod 220.

In other embodiments, the positions of the first guide bend portion 223 and the second guide bend portion 225 on the same side of the first support rod 220 can be interchanged, that is, the positions of the first guide bend portion 223 and the second guide bend portion 225 on one side of the first support rod 220 are interchanged, and the positions of the second guide bend portion 223 and the second guide bend portion 225 on the opposite side of the first support rod 220 are interchanged.

As shown in FIGS. 7-10, in the embodiments, on each of the two opposite sides of each first support rod 220, the first support rod 220 is arranged with two first guide bend portions 223 and two second guide bend portions 225 spaced apart from each other. On one side of the first support rod 220, the two first guide bend portions 223 are arranged at two opposite ends of the first rod body 221 along the length direction, and the two second guide bend portions 225 are arranged at the two opposite ends of the first rod body 221 along the length direction. On the other side of the first support rod 220, the two first guide bend portions 223 are arranged at two opposite ends of the first rod body 221 along the length direction, and the two second guide bend portions 225 are arranged at the two opposite ends of the first rod body 221 along the length direction. Among two first guide bend portions 223 and two second guide bend portions 225 at the same end of the first support rod 220, the first guide bend portion 223 on one side faces directly the second guide bend portion 225 on the other side in the first direction (i.e., the X-axis direction). The axis lines of the two first curved surfaces 2230 and the two second curved surfaces 2250 on the same side of the first support rod 220 are co-linear. Specifically, two first guide bend portions 223 on one side of the first rod body 221 are disposed near the opposite ends of the first rod body 221, two second guide bend portions 225 on the same side of the first rod body 221 are disposed near the opposite ends of the first rod body 221, and the two second guide bend portions 225 are disposed between the two first guide bend portions 223; two first guide bend portions 223 on the other side of the first rod body 221 are disposed near the opposite ends of the first rod body 221, two second guide bend portions 225 on the same side of the first rod body 221 are disposed near the opposite ends of the first rod body 221, and the two first guide bend portions 223 are disposed between the two second guide bend portions 225. Two first guide bend portions 223 on one side of the first rod body 221 are misaligned with two first guide bend portions 223 on the other side of the first rod body 221, and two second guide bend portions 225 on one side of the first rod body 221 are misaligned with two second guide bend portions 225 on the other side of the first rod body 221. Two first guide bend portions 223 on one side of the first rod body 221 correspond one-to-one with two second guide bend portions 225 on the other side of the first rod body 221, and two second guide bend portions 225 on one side of the first rod body 221 correspond one-to-one with two first guide bend portions 223 on the other side of the first rod body 221.

In some embodiments, on each of the both opposite sides of the first rod body 220, the first support rod 220 is arranged with one first guide bend portion 223 and one second guide bend portion 225 spaced apart from each other on opposite sides. The first guide bend portion 223 and the second guide bend portion 225 on one side of the first support rod 220 are disposed close to the middle of the first support rod 220, and the first guide bend portion 223 and the second guide bend portion 225 on the other side of the first support rod 220 are disposed close to the middle of the first support rod 220. The first guide bend portion 223 on one side of the first support rod 220 faces directly the second guide bend portion 225 on the other side of the first support rod 220 along the first direction (i.e., the X-axis direction), and the second guide bend portion 225 on one side of the first support rod 220 faces directly the first guide bend portion 223 on the other side of the first support rod 220 along the first direction (i.e., the X-axis direction).

In some embodiments, on each of the both opposite sides of the first rod body 220, the first support rod 220 is arranged with three or more first guide bend portions 223 and three or more second guide bend portions 225 spaced apart from each other. The number of the first guide bend portions 223 on one side of the first support rod 220 is the same as the number of the second guide bend portions 225 on the other side of the first support rod 220. The three or more first guide bend portions 223 on one side of the first support rod 220 correspond one-to-one with the three or more second guide bend portions 225 on the other side of the first support rod 220, and the three or more second guide bend portions 225 on one side of the first support rod 220 correspond one-to-one with the three or more first guide bend portions 223 on the other side of the first support rod 220.

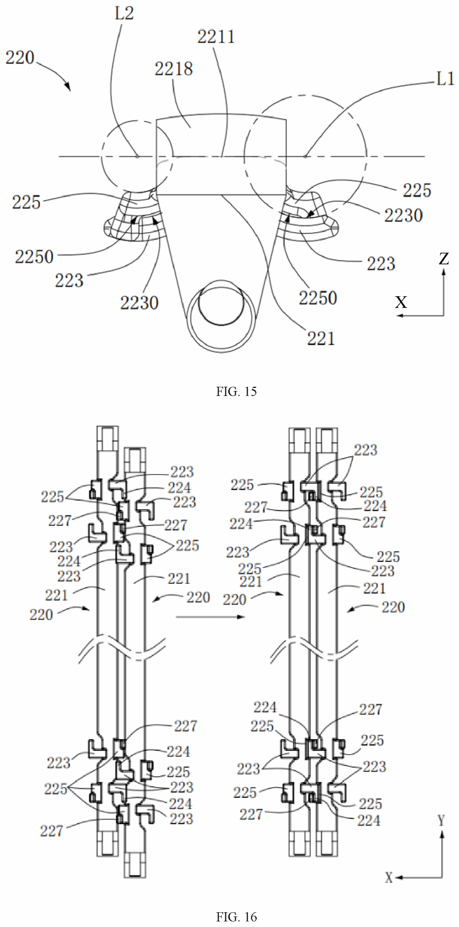

In some embodiments, as shown in FIG. 15, a plane where the axis lines of the two first curved surfaces 2230 on the both opposite sides of the first support rod 220 lie is coplanar with the front surface of the first rod body 221, or a plane where the axis lines of the two second curved surfaces 2250 on the both opposite sides of the first support rod 220 lie is coplanar with the front surface of the first rod body 221. Specifically, the axis line of the first curved surface 2230 is co-linear with the axis line of the second curved surface 2250 on the same side of the first support rod 220, the axis lines of the two first curved surfaces 2230 on the opposite sides of the first support rod 220 are parallel to each other, and the plane in which the two axis lines lie are coplanar with the front surface 2211 of the first rod body 221. The plane in which the axis lines of the first curved surfaces 2230 and the second curved surfaces 2250 lie are coplanar with the front surface 2211 of the first rod body 221. Specifically, the first axis line L1 of the first curved surface 2230 on one side of the first support rod 220 is parallel to the second axis line L2 of the second curved surface 2250 on the other side of the first support rod 220, and the plane defined by the first axis line L1 and the second axis line L2 is coplanar with the front surface 2211.

As shown in FIGS. 5 and 11-15, the first support rod 220 further includes a connecting portion 226 connected to the back surface 2213 of the first rod body 221, and a support portion 228 connected to an end of the connecting portion 226 away from the first guide bend portion 223. An end of the connecting portion 226 disposed near the end of the first rod body 221, the support portion 228, the connecting portion 226, and the first rod body 221 encloses to define a sliding guide space 2282, and the sliding guide space 2282 is configured to contain the guide rail 260. Specifically, the connecting portion 226 extends in the Z-axis direction from the back surface 2213 of the first rod body 221 towards the end surface 2216, and the width of the connecting portion 226 in the X-axis direction gradually decreases along the extension direction of the connecting portion 226, such that the width of the end of the connecting portion 226 connected to the first rod body 221 in the X-axis direction is greater than the width of the end of the connecting portion 226 away from the first rod body 221 in the X-axis direction. The support portion 228 extends from the end of the connecting portion 226 away from the first rod body 221 in the Y-axis direction away from the first guide bend portion 223. In some embodiments, the support portion 228 is a circular column. In the above embodiments, the back surface 2213 of the first rod body 221 is arranged with the connecting portion 226 on each of the both opposite end, and the support member 228 is arranged on a side of each connecting portion 226 away from the first rod body 221 at the end away from the first guide bend portion 223. Each connecting portion 226, together with its corresponding support member 228 and corresponding first rod body 221, forms the sliding guide space 2282, that is, the sliding guide space 2282 is defined at each end of the first rod body 221. In some embodiments, an end surface of the connecting portion 226 away from the first rod body 221 is arranged with a curved surface, and the support portion 228 is a circular column, the peripheral surface of which is coplanar with the curved surface.

The first support rod 220 further includes a rolling member 222, which is movably arranged on the support portion 228 or the connecting portion 226. When the first support rod 220 is moved relative to the guide rail 260, the rolling member 222 is in rolling contact with the guide rail 260, such that the first support rod 220 is in rolling connection with the guide rail 260, thereby reducing the frictional resistance between the first support rod 220 and the guide rail 260, which is conducive to the support apparatus 22 moving around the guide rail 260. In the present embodiments, the rolling member 222 is arranged on a side of the support portion 228 facing the first rod body 221, and the rolling member 222 may be, but is not limited to, a hard ball such as a metal ball. In other embodiments, the rolling member 222 may be a rolling cylinder, and the axis line of the rolling cylinder is parallel to the axis line of the first curved surface 2230. Specifically, the support portion 228 is offset from the first guide bend portion 223, and the support portion 228 defines a containment groove 2280, the opening of the containment groove 2280 being communicated to the sliding guide space 2282. The rolling member 222 is placed in the containment groove 2280 in a rollable manner, and part of the outer surface of the rolling member 222 is exposed from the containment groove 2280. The support member 228 is connected to a side of the connecting portion 226 away from the first stop portion 224, the opening of the containment groove 2280 is communicated with the sliding guide space 2282, and the part of the outer surface of the rolling member 222 exposed from the containment groove 2280 is disposed in the sliding guide space 2282.

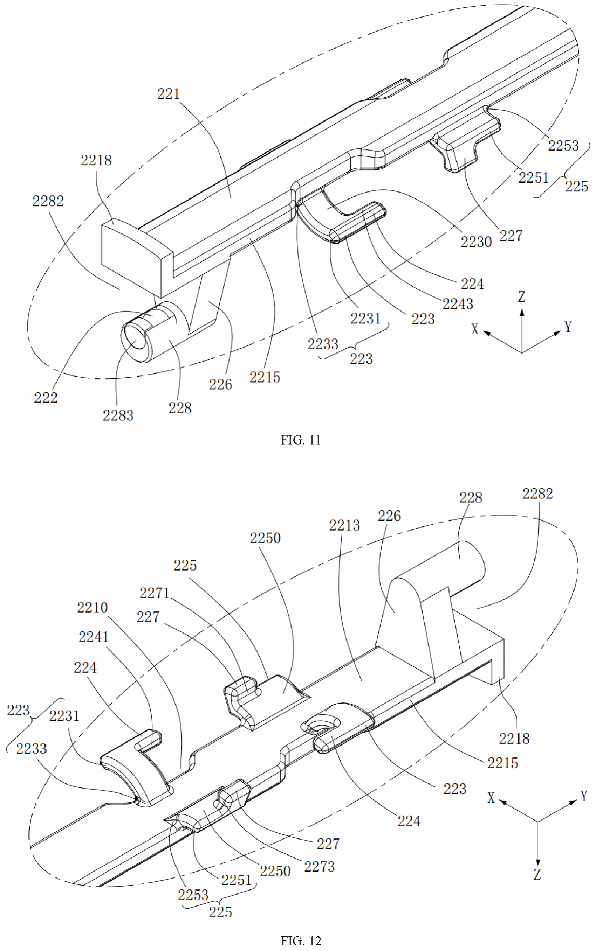

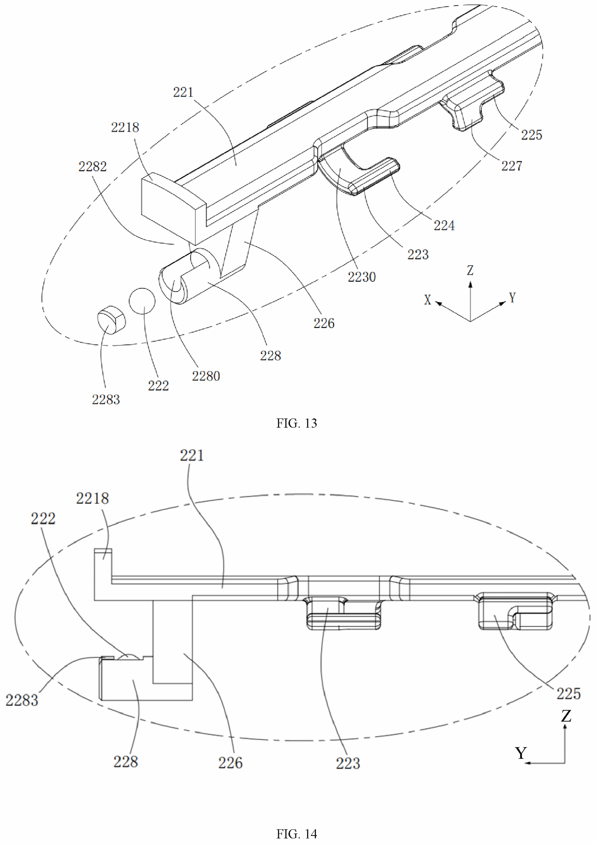

As shown in FIGS. 11 and 13, in the embodiments, the first support rod 220 further includes a positioning member 2283. The containment groove 2280 is defined on the surface of the support portion 228 facing the first rod body 221, and the positioning member 2283 is accommodated in the containment groove 2280. The positioning member 2283 is configured to prevent the rolling member 222 from disengaging from the containment groove 2280. Specifically, the containment groove 2280 extends along the extension direction of the support portion 228 (i.e., along the Y-axis direction) away from the connecting portion 226, and the end of the containment groove 2280 away from the connecting portion 226 penetrates the end surface of the connecting portion 226 to form an entrance, through which the rolling member 222 is loaded into the containment groove 2280. In the embodiments, the positioning member 2283 is a soft rubber stopper, and the positioning member 2283 is inserted into the support member 228 from the entrance of support portion 228 to prevent the rolling member 222 from disengaging from the containment groove 2280. In other embodiments, the positioning member 2283 may be a hard stopper.

In the embodiments, the first support rod 220 is made of liquid metal by injection molding, i.e. the first rod body 221, the first guide bend portion 223, the first stop portion 224, the second guide bend portion 225, the second stop portion 227, the connecting portion 226, the support portion 228, and the stop portion 2218 are integrally formed. In this way, the first support rod 220 is easy to process and has low manufacturing costs. In other embodiments, the first support rod 220 may be made of other hard materials.

During the assembling process of each first support rod 220, two rolling members 222 are respectively loaded into the containment grooves 2280 through the entrances of the two support members 228, such that each rolling member 222 can roll in the corresponding containment groove 2280; and two positioning elements 2283 are respectively loaded into the containment grooves 2280 through the entrances of the two support members 228, so as to prevent each rolling member 222 from being separated from the corresponding containment groove 2280. Each first support rod 220 of the present disclosure can be assembled without the use of tools, which is simple and convenient.

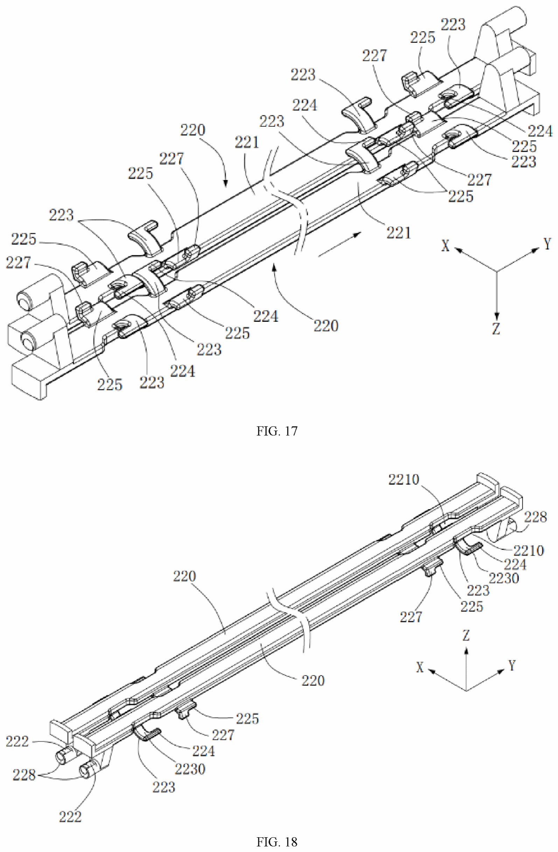

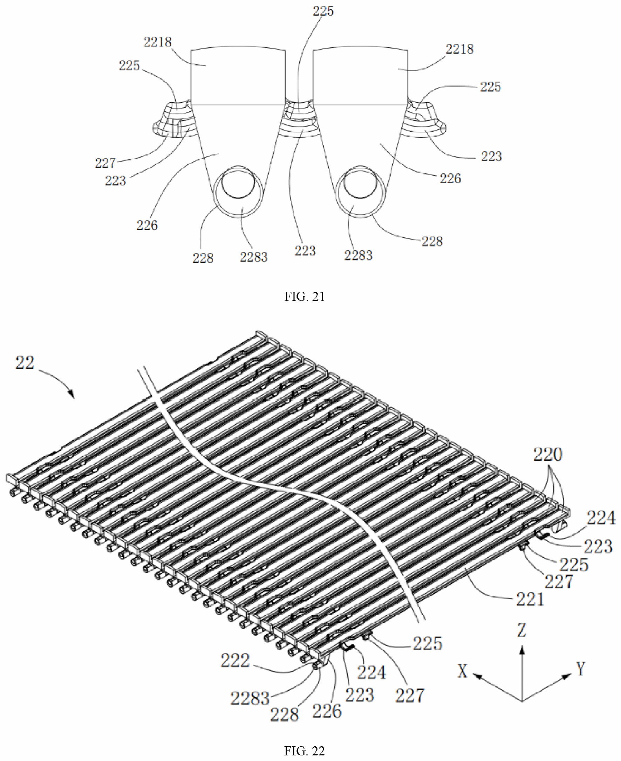

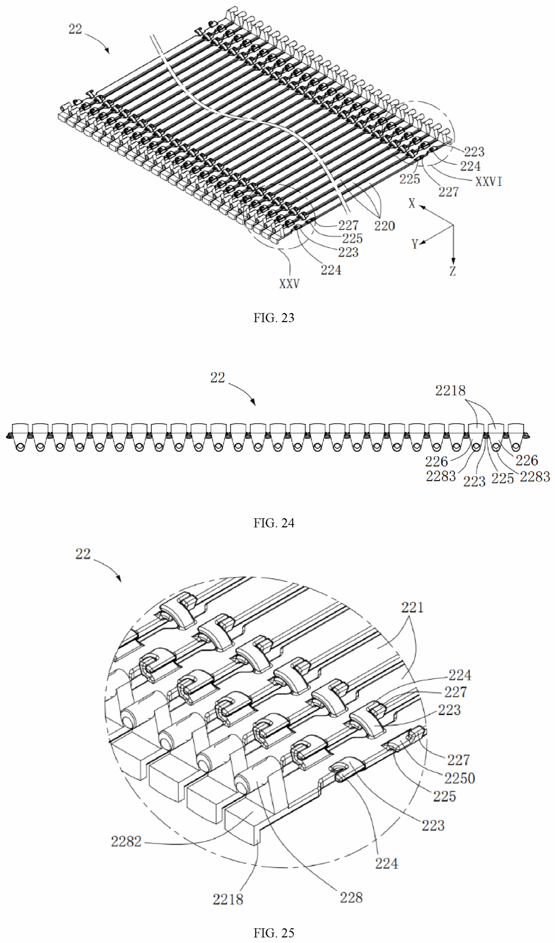

Further referring to FIGS. 16-26, during the assembling process of the support apparatus 22, one first support rod 220 is placed on a side of another first support rod 220, such that the first rod bodies 221 of the two first support rods 220 are parallel to each other. The two first support rods 220 are misaligned in the Y-axis direction, such that the first guide bend portion 223 and second guide bend portion 225 of one first support rod 220 are misaligned from the second guide bend portion 225 and first guide bend portion 223 of the other first support rod 220 in the Y-axis direction, the first guide bend portion 223 of one first support rod 220 is aligned with the second guide bend portion 225 of the other first support rod 220 in the first direction (i.e., the X-axis direction), and the first stop portion 224 and its corresponding second stop portion 227 are misaligned from each other in the X-axis direction. One of the first support rods 220 is moved relative to the other along the Y-axis direction, such that the first guide bend portion 223 of one first support rod 220 overlaps the corresponding second guide bend portion 225, and thus each first curved surface 2230 and its corresponding second curved surface 2250 are fitted to each other rotatably. In this case, the two first support rods 220 are bendably connected to each other, where the first guide bend portion 223 of one first support rod 220 is rotatably connected to the second guide bend portion 225 of the other first support rod 220 in a lapping manner, and the first guide bend portion 223 of the other first support rod 220 is rotatably connected to the second guide bend portion 225 of the one first support rods 220 in a lapping manner; and each first stop portion 224 is matched with its corresponding second stop portion 227, i.e., the first stop surface 2241 of the first stop portion 224 faces directly the third stop surface 2271 of the corresponding second stop portion 227 in the first direction (i.e., the X-axis direction). After all the first support rods 220 are assembled together according to the above method, the support apparatus 22 is hinged as a whole, with the first guide bend portions 223 of each first support rod 220 on both sides being rotatably connected to the second guide bend portions 225 of adjacent two first support rods 220 in a lapping manner. Each adjacent two first support rods 220 are connected by the cooperation between the first curved surface 2230 and the second curved surface 2250, such that the folding or flattening of the support apparatus 22 is smooth. The support apparatus 22 of the present disclosure can be assembled by interlocking the first support rods 220 with each other without the need for tools, which is convenient and quick to install and has low assembly costs. The first support rods 220 of the support apparatus 22 are assembled together by the first guide bend portion 223 and the second guide bend portion 225 to form a hinged integral structure, which is convenient and simple to assemble. In addition, during the rolling or flattening process, each pair of adjacent first support rods 220 transfers force to each other, such that the support apparatus 22 can roll or flatten smoothly.

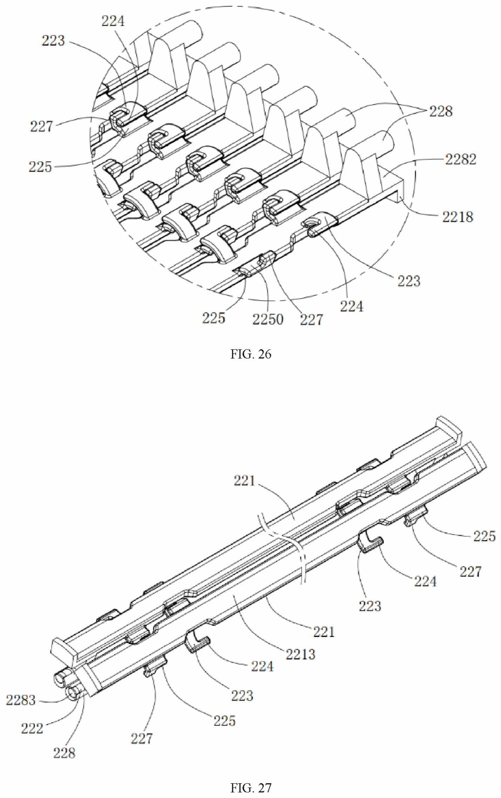

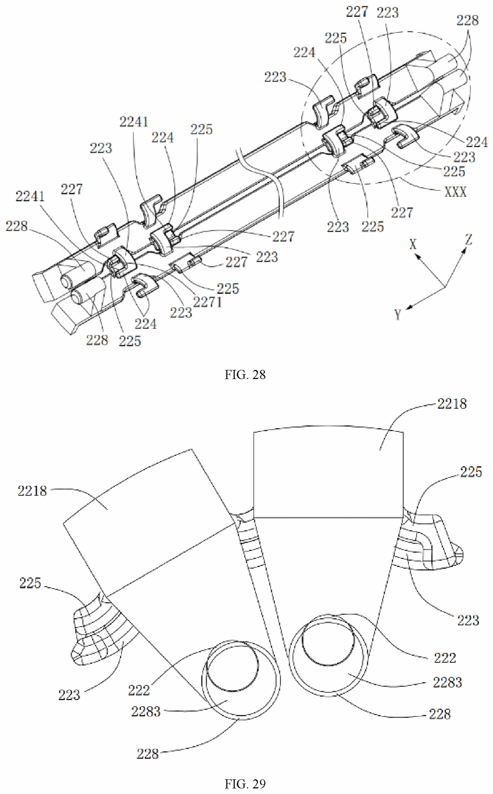

As shown in FIGS. 27-30, when two adjacent first support rods 220 are connected to each other, the first guide bend portion 223 of one first support rod 220 is rotatably connected to the second guide bend portion 225 of the other first support rod 220 in a lapping manner, and the first guide bend portion 223 of the other first guide bend portion 223 of the first support rod 220 is rotatably connected to the second guide bend portion 225 of the one first support rod 220 in a lapping manner, such that each first curved surface 2230 and its corresponding second curved surface 2250 slidably abut against each other. When two adjacent first support rods 220 are flattened, the front surfaces 2211 of the two first support rods 220 are coplanar, and the first end 2231 of the first guide bend portion 223 of each first support rod 220 is away from the back surface 2213 of the adjacent first support rod 220. The first curved surface 2230 of each first guide bend portion 223 abuts against the second curved surface 2250 of the corresponding second guide bend portion 225, and the first stop portion 224 and second stop portion 227, that are adjacent to each other, stop each other, that is, the first stop portion 224 of one first support rod 220 abuts against the second stop portion 227 of the other first support rod 220 to prevent the two first support rods 220 from folding back. When the two adjacent first support rods 220 are bent relative to each other, the front surfaces 2211 of the two first support rods 220 bend relative to each other, the first curved surface 2230 of each first guide bend portion 223 abuts against the second curved surface 2250 of the corresponding second guide bend portion 225, and the first end 2231 of the first guide bend portion 223 of each first support rod 220 is close to or abuts against the back surface 2213 of the adjacent first support rod 220, and the first stop portion 224 and second stop portion 227, that are adjacent to each other, are spaced apart from each other, i.e., the first stop portion 224 of one first support rod 220 is spaced apart from the second stop portion 227 of the other first support rod 220, such that the two first support rods 220 are not obstructed from bending relative to each other.

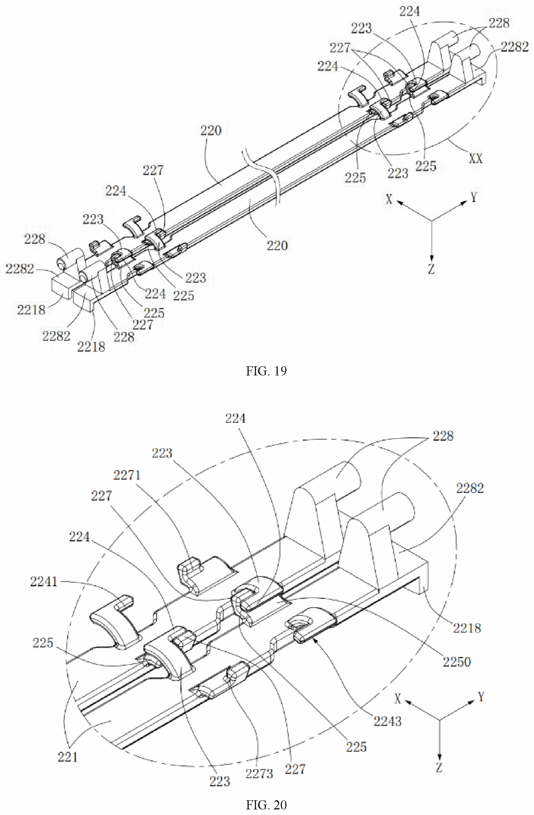

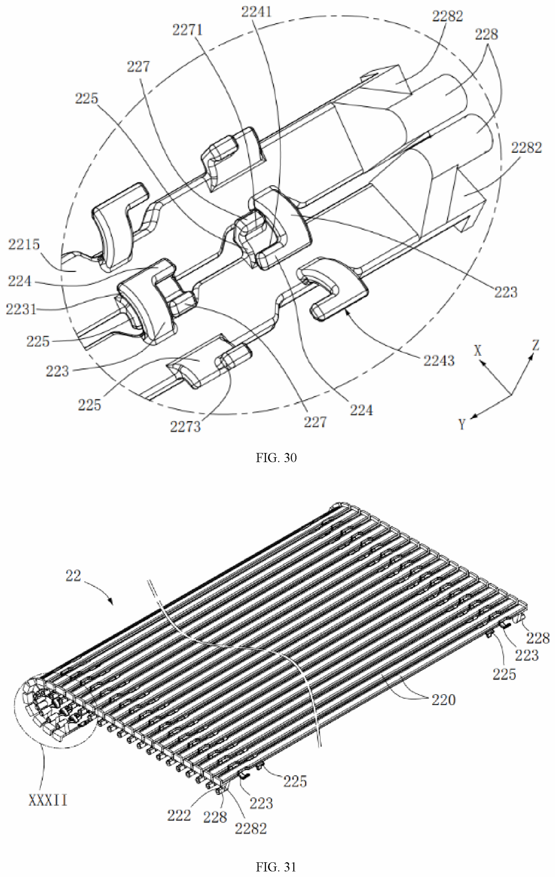

The two adjacent first support rods 220 can only be switched between the unfolded (flattened) state and the bent state, as shown in FIG. 20. When the two first support rods 220 are unfolded relative to each other, the first stop surface 2241 of the first stop portion 224 of one first support rod 220 and the third stop surface 2271 of the second stop portion 227 of the other first support rod 220 mutually abut against each other, such that the two first support rods 220 are positioned relative to each other in the X-axis direction; the second stop surface 2243 of the first stop portion 224 of one first support rod 220 and the corresponding second curved surface 2250 of the other first support rod 220 mutually abut against each other, such that the two first support rods 220 are positioned relative to each other in the Z-axis direction; the fourth stop surface 2273 of the second stop portion 227 of the other first support rod 220 and the first guide bend portion 223 of the one first support rod 220 mutually abut against each other, such that the two first support rods 220 are positioned relative to each other in the Y-axis direction. Therefore, when the two first support rods 220 are in the unfolded state, the two first support rods 220 can be positioned in the X-axis direction, Y-axis direction, and Z-axis direction, such that the two first support rods 220 maintain a stable flattened state, improving the flatness of the two first support rods 220 and preventing the two first support rods 220 from folding back. As shown in FIG. 30, when the two first support rods 220 bend against each other, the first stop surface 2241 of the first stop portion 224 of one first support rod 220 separates from the third stop surface 2271 of the second stop portion 227 of the other first support rod 220, such that the two first support rods 220 become loose in the X-axis direction; the second stop surface 2243 of the first stop portion 224 of one first support rod 220 and the corresponding second curved surface 2250 of the other first support rod 220 mutually abut against each other, such that the two first support rods 220 are positioned relative to each other in the Z-axis direction; the fourth stop surface 2273 of the second stop portion 227 of the other first support rod 220 and the first guide bending portion 223 of one of the first support rods 220 mutually abut against each other, such that the two first support rods 220 are positioned relative to each other in the Y-axis direction. Therefore, when the two first support rods 220 are in the bent state, the two first support rods 220 can be bent or flattened along the fit between the first curved surface 2230 and the second curved surface 2250.

Further referring to FIGS. 1-5, during the assembling process of the electronic device 100, two sliding guide rails 271 are placed in the first storage space 247 of the first housing 24 in parallel intervals and positioned on the first bottom wall 243; two sliding guide blocks 273 are placed in the second storage space 2627 of the second housing 26 in intervals and positioned on the second bottom wall 2623; the two sliders 2628 of the second housing 26 are respectively slidably inserted into the two guide slots 2415 of the first housing 24, the two sliding guide blocks 273 on the second housing 26 are respectively slidably connected to the two sliding guide rails 271, and the multiple sliding guide rods 2624 are respectively slidably inserted into the multiple sliding guide slots 2411; the back surface of the sliding and rolling area 54 of the flexible screen 50 is connected to the support apparatus 22 via an adhesive layer, and more specifically, an adhesive is applied to the front surface of the first support rod 220, and the back surface of the sliding and rolling area 54 is then affixed to the front surface of the first support rod 220, such that the flexible screen 50 is glued to the support apparatus 22. In this case, the rotation axis line between the adjacent two first support rods 220 of the support apparatus 22 is disposed in the adhesive layer; the fixed area 52 is accommodated in the positioning groove 2410 of the first housing 24, and the back surface of the fixed area 52 is fixedly affixed to the front surface of the first top wall 241, and the positioning strip 521 is snapped into the connecting slot 2413 of the first housing 24; a side of the support apparatus 22 away from the flexible screen 50 is wrapped around the second housing 26, that is, the support apparatus 22 and the sliding and rolling area 54 are wrapped around the second top wall 2621, the second side wall 2625, and the second bottom wall 2623 of the second housing 26; the first support rod 220 of the support apparatus 22, which is disposed near the fixed area 52, is connected to the first housing 24, and the first support rod 220 of the support apparatus 22, which is disposed away from the fixed area 52, is connected to the guide rail 260 via an end fitting 229, the end fitting 229 including a connecting plate 2291, a support plate 2293 arranged on an end of the connecting plate 2291, and a sliding guide post 2295 arranged on the support plate 2293; where the sliding guide space 2282 is defined between the sliding guide post 2295 and the connecting plate 2291, the guide rail 260 is slidably accommodated in the sliding guide space 2282, and the sliding guide post 2295 is in sliding contact with the guide rail 260; two blocking members 265 are respectively connected to the two second end walls 2626 of the second housing 26, and specifically, multiple fasteners such as screws are respectively secured to corresponding connecting holes through the through holes 2655, and a snap-in block 2656 of each blocking member 265 is snapped into a corresponding snap hole of the second end wall 2626; in this case, the support apparatus 22 is wound around the second housing 26 and at least part of the guide rail 260 can be slidably accommodated in the sliding guide space 2282 of the support apparatus 22, and the rolling member 222 is in rolling contact with the guide rail 260. Specifically, the guide rails 260 of the two blocking members 265 are accommodated in the sliding guide spaces 2282 at the opposite ends of the support apparatus 22, the rolling members 222 are in rolling contact with the corresponding guide rails 260, and the curved rail 2603 and the outer side of the second side wall 2625 are coaxial; the cover plate 2671 of the end cover 267 is covered on the sliding and rolling area 54 on the side of the second housing 26 away from the first housing 24, and the two connecting plates 2673 cover the ends of the two blocking members 265 away from the first housing 24, such that the positioning hole 2676 on each connecting plate 2673 faces the corresponding through hole 2655 and corresponding connecting hole, and two fasteners such as screws are respectively passed through the two positioning holes 2676 and through holes 2655 and secured in the corresponding connecting holes. In this way, the cover plate 2671 is fixedly connected to the second housing 26, and the support apparatus 22 and flexible screen 50 surrounding the second side wall 2625 can be slidably accommodated in the storage space 2674.

In this case, the connecting portion 226, the support portion 228, the first guide bend portion 223, and the second guide bend portion 225 of the support apparatus 22 are disposed on the back side of the first support rod 220 near the end surface, rather than directly on the end surface of the first support rod 220. Therefore, the connecting portion 226, the support portion 228, the first guide bend portion 223 and the second guide bend portion 225 are avoided from taking up space on the opposite sides of the housing assembly 20. In addition, the blocking member 265 covers the connecting portion 226, support portion 228, first guide bend portion 223, and second guide bend portion 225 of the first support rod 220, thereby preventing external dust and debris from entering the interior of the housing assembly 20. Moreover, the connecting portion 226, the support portion 228, the first guide bend portion 223, and the second guide bend portion 225 are not exposed, thereby improving the overall appearance of the electronic device 100. Furthermore, the rotation axis line between each adjacent first support rod 220 is disposed on the adhesive layer of the first support rod 220, that is, the axis line of the first curved surface 2230 and the axis line of the second curved surface 2250 are both disposed on the adhesive layer connecting the first support rod 220 and the flexible screen 50, such that the support apparatus 22 is not compressed or stretched during bending or flattening, thereby effectively protecting the adhesive layer from damage and preventing the flexible screen 50 from detaching from the first support rod 220, and thus ensuring a stable and firm connection between the flexible screen 50 and the support apparatus 22.

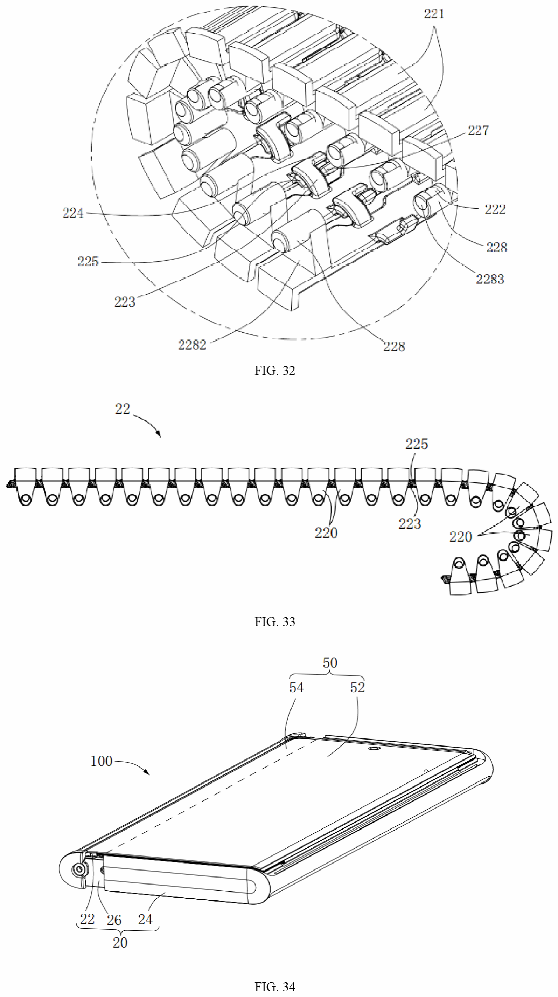

As shown in FIGS. 1-6 and 31-33, the unfolding process of the flexible screen 50 of the electronic device 100 is as follows: the first housing 24 and/or the second housing 26 are pulled by an external force (e.g., a pushing force from the user), such that the first housing 24 and the second housing 26 slide away from each other, the sliding guide rod 2624 slides away from the first housing 24, the slider 2628 slides along the corresponding guide slot 2415 away from the first housing 24, and the sliding guide block 273 slides along the corresponding sliding guide rail 271 away from the first housing 24; the sliding frame 262 slides relative to the support apparatus 22 such that the support apparatus 22 unfolds and the support apparatus 22 slides around the second housing 26; specifically, the first support rods 220, which are attached to the second bottom wall 2623, are bent along the outer side of the second side wall 2625 and then flattened on the front surface of the second top wall 2621 by sliding. The first support rod 220 of the support apparatus 22 away from the first housing 24 slides away from the first housing 24, until the end fitting 229 slides to abut against the curved rail 2603, and the sliding and rolling area 54 is fully unfolded along with the support apparatus 22.

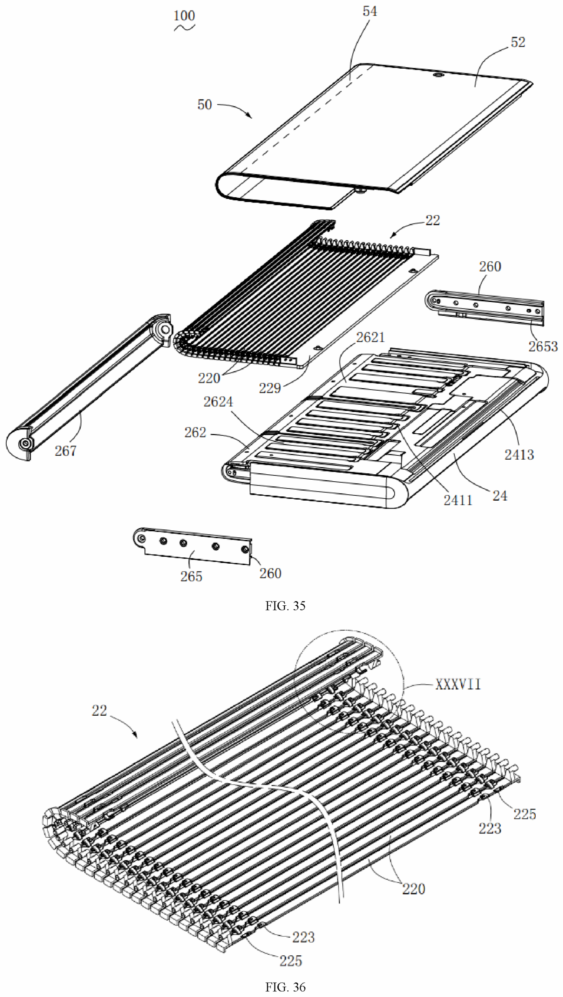

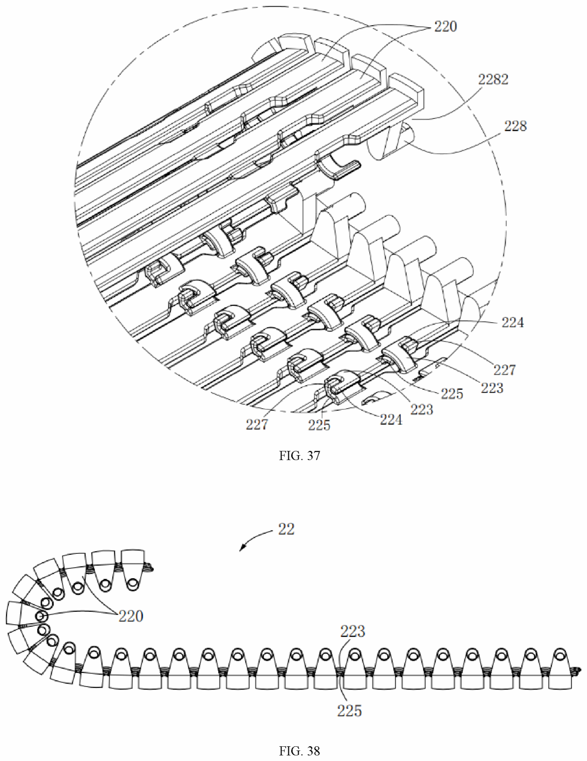

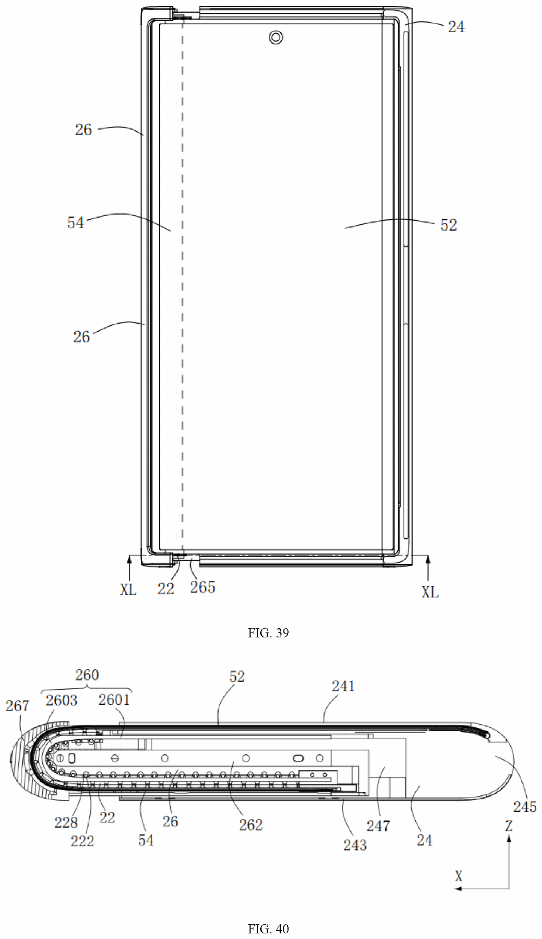

Further referring to FIGS. 1-6 and FIGS. 34-40, the rolling process of the flexible screen 50 of the electronic device 100 is as follows: the first housing 24 and/or the second housing 26 are pushed by an external force (e.g., a pushing force from the user), causing the first housing 24 and the second housing 26 to slide relative to each other and contract. The sliding guide rod 2624 slides along the corresponding sliding guide slot 2411 and moves closer to the first housing 24, the slider 2628 slides along the corresponding guide slot 2415 and moves closer to the first housing 24, and the sliding guide block 273 slides along the corresponding sliding guide rail 271 and moves closer to the first housing 24; the sliding frame 262 slides relative to the support apparatus 22, causing the support apparatus 22 to roll, such that the support apparatus 22 slides around the second housing 26; specifically, the first support rod 220, which is attached to the second bottom wall 2623, are bent along the outer side of the second side wall 2625 and then flattened on the bottom surface of the second top wall 2621 by sliding. The first support rod 220 of the support apparatus 22 away from the first housing 24 slides towards the first housing 24 until the end fitting 229 slides to abut against the first housing 24, and the sliding and rolling area 54 completely rolls up with the support apparatus 22.

During the above-mentioned unfolding process or rolling process of the flexible screen 50, force is transmitted between each adjacent two first supporting rods 220 through the cooperation of the first guide bend portion 223 and the second guide bend portion 225, thereby reducing the stress on the flexible screen 50, protecting the flexible screen 50, and thus improving the reliability of the flexible screen 50. In addition, the flexible screen 50 will not appear creases after being rolled multiple times, which may not affect the appearance and thus enhances the user experience. The rolling member 222 is in rolling contact with the corresponding guide rail 260, which makes the friction resistance of the sliding of the support apparatus 22 relative to the guide rail 260 small, thereby facilitating the unfolding of the support apparatus 22 and the flexible screen 50. As the outer side of the second side wall 2625 is a curved surface, and the outer side of the second side wall 2625 is coaxial with the curved rail 2603, it is convenient for the support apparatus 22 to bend along the outer side of the second side wall 2625. Each pair of adjacent first support rods 220 is connected to each other via the first guide bend portion 223 and the second guide bend portion 225, whereby the first curved surface 2230 and the corresponding second curved surface 2250 are in sliding contact with each other, such that the bending and unfolding of the support apparatus 22 is smooth. When each pair of adjacent first support rods 220 is flattened along the outer side of the second side wall 2625, the first stop portion 224 and the second stop portion 227 are positioned against each other to prevent the two first support rods 220 from bending in the opposite direction (folding back), so as to ensure that the two first support rods 220 have a stable flatness to support the flexible screen 50 stably, and to prevent the first support rods 220 from folding back and arching the flexible screen 50, thereby effectively protecting the flexible screen 50.

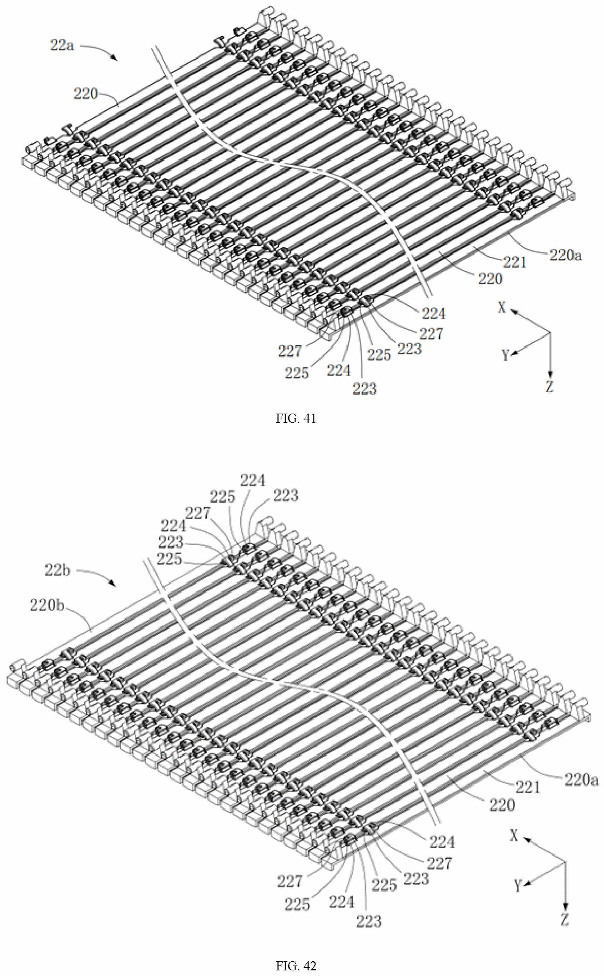

Referring to FIG. 41, the structure of the support apparatus 22a in another embodiment of the present disclosure is similar to the structure of the support apparatus 22 in one of the above embodiments. The difference is that the support apparatus 22a further includes a second support rod 220a, which is connected to the outermost first support rod 220 among the multiple first support rods 220, where the outermost first support rod 220 referring to one of the two outermost first support rods 220 among the multiple first support rods 220; the second support rod 220a is rotatably connected to the first support rod 220 via the first guide bend portion 223 and the second guide bend portion 225. The second support rod 220a is similar in structure to the first support rod 220, except that the second support rod 220a omits the first guide bend portion 223 and the second guide bend portion 225 on a side of the first support rod 220. Specifically, a side of the second support rod 220a facing the first support rod 220 is arranged with the first guide bend portion 223 and the second guide bend portion 225, and a side of the second support rod 220a away from the first support rod 220 is not arranged with the first guide bend portion 223 and the second guide bend portion 225, so as to facilitate the connection of the second support rod 220a to the housing assembly of the electronic device.

Referring to FIG. 42, the structure of the support apparatus 22b in another embodiment of the present disclosure is similar to the structure of the support apparatus 22 in one of the above embodiments. The difference is that the support apparatus 22b further includes a second support rod 220a and a third support rod 220b, the second support rod 220a being connected to one of two outermost first support rods 220 among the multiple first support rods 220, and the third support rod 220b being connected to the other outermost first support rod 220; that is, the second support rod 220a and the third support rod 220b are respectively connected to the two first support rods 220 on the opposite outermost sides of the multiple first support rods 220; specifically, the third support rod 220b is connected to the first support rods 220, among the first support rods 220, away from the second support rod 220a, and the second support rod 220a is connected to the first support rod 220, among the first support rods 220, away from the third support rod 220b; the first support rods 220 are disposed between the second support rod 220a and the third support rod 220b; the second support rod 220a is rotatably connected to the corresponding first support rod 220 by means of a first guide bend portion 223 and a second guide bend portion 225, and the third support rod 220b is rotatably connected to the corresponding first support rod 220 by means of a first guide bend portion 223 and a second guide bend portion 225. The second support rod 220a is similar in structure to the first support rod 220, except that the second support rod 220a omits the first guide bend portion 223 and the second guide bend portion 225 on a side of the first support rod 220. Specifically, a side of the second support rod 220a facing the first support rod 220 is arranged with the first guide bend portion 223 and the second guide bend portion 225, and a side of the second support rod 220a away from the first support rod 220 is not arranged with the first guide bend portion 223 and the second guide bend portion 225, so as to facilitate the connection of the second support rod 220a to the housing assembly of the electronic device. The third support rod 220b is similar in structure to the first support rod 220, except that the third support rod 220b omits the first guide bend portion 223 and the second guide bend portion 225 on a side of the first support rod 220. Specifically, a side of the third support rod 220b facing the first support rod 220 is arranged with the first guide bend portion 223 and the second guide bend portion 225, and a side of the third support rod 220b away from the first support rod 220 is not arranged with the first guide bend portion 223 and the second guide bend portion 225, so as to facilitate the connection of the third support rod 220b to the end fitting of the housing assembly.

## Claims

1. A support apparatus (22, 22a, 22b), comprising a plurality of first support rods (220) that are rotatably connected to each other along a first direction; wherein each of the plurality of first support rods (220) comprises a first rod body (221), at least one first guide bend portion (223), and at least one second guide bend portion (225); the first rod body (221) comprises two opposite sides along the first direction, **characterized in that**,
each of the two opposite sides of the first rod body (221) is arranged with the at least one first guide bend portion (223) and the at least one second guide bend portion (225); for each adjacent two first support rods (220) of the plurality of first support rods (220), the at least one first guide bend portion (223) on a first side of one of the adjacent two first support rods (220) rotatably abuts against the at least one second guide bend portion (225) on a second side of the other of the adjacent two first support rods (220), and the at least one second guide bend portion (225) on the first side of the one of the adjacent two first support rods (220) rotatably abuts against the at least one first guide bend portion (223) on the second side of the other of the adjacent two first support rods (220).

2. The support apparatus (22, 22a, 22b) according to claim 1, wherein the at least one first guide bend portion (223) comprises a first curved surface (2230), the at least one second guide bend portion (225) comprises a second curved surface (2250), and the first curved surface (2230) and the second curved surface (2250) on a same side of each first support rod (220) have a coaxial line; the first curved surface (2230) on the first side of one of the adjacent two first support rods (220) rotatably abuts against the second curved surface (2250) on the second side of the other of the adjacent two first support rods (220), and the second curved surface (2250) on the first side of one of the adjacent two first support rods (220) rotatably abuts against the first curved surface (2230) on the second side of the other of the adjacent two first support rods (220).

3. The support apparatus (22, 22a, 22b) according to claim 1, wherein the at least one first guide bend portion (223) and the at least one second guide bend portion (225) on a same side of each first support rod (220) are spaced apart along a length direction of the first rod body (221) of the first support rod (220); the at least one first guide bend portion (223) on one of the two opposite sides of the first support rod (220) faces the at least one second guide bend portion (225) on the other of the two opposite sides of the first support rod (220) along the first direction, the length direction of the first rod body (221) being perpendicular to the first direction.

4. The support apparatus (22, 22a, 22b) according to claim 2, wherein the at least one first guide bend portion (223) further comprises a first curved strip arranged on a back surface of the first rod body (221), and the at least one second guide bend portion (225) further comprises a second curved strip arranged on a back surface of the first rod body (221); the first curved surface (2230) is arranged on a surface of the first rod body (221) facing the first curved strip, and the second curved surface (2250) is arranged on a surface of the second curved strip away from the first rod body (221).

5. The support apparatus (22, 22a, 22b) according to claim 2, wherein the first support rod (220) further comprises a first stop portion (224) connected to the at least one first guide bend portion (223) and a second stop portion (227) connected to the at least one second guide bend portion (225);
in a case where the adjacent two first support rods (220) are flattened, the first stop portion (224) of one of the adjacent two first support rods (220) and the second stop portion (227) of the other of the adjacent two first support rods (220) abut against each other;
in a case where the adjacent two first support rods (220) are bent relative to each other, the first stop portion (224) of one of the adjacent two first support rods (220) and the second stop portion (227) of the other of the adjacent two first support rods (220) move away from each other.

6. The support apparatus (22, 22a, 22b) according to claim 5, wherein the first stop portion (224) is arranged on an end of the at least one first guide bend portion (223) away from the first rod body (221), the second stop portion (227) is arranged on an end of the at least one second guide bend portion (225) away from the first rod body (221), and the first stop portion (224) on a side of the first rod body (221) directly faces the second stop portion (227) on an opposite side of the first rod body (221) in the first direction.

7. The support apparatus (22, 22a, 22b) according to claim 6, wherein the first stop portion (224) on the side of the first rod body (221) comprises a first stop surface (2241) facing the second stop portion (227) on the opposite side of the first rod body (221), and a second stop surface (2243) facing the first rod body (221); the second stop portion (227) on the side of the first rod body (221) comprises a third stop surface (2271) facing the first stop portion (224) on the opposite side of the first rod body (221), and a fourth stop surface (2273) facing the first stop portion (224) along a length direction of the first rod body (221);
in a case where the adjacent two first support rods (220) are flattened, the first stop surface (2241) of one of the adjacent two first support rods (220) and the third stop surface (2271) of the other of the adjacent two first support rods (220) abut against each other, the second stop surface (2243) of the one of the adjacent two first support rods (220) and a corresponding second curved surface (2250) of the other of the adjacent two first support rods (220) abut against each other, and the fourth stop surface (2273) of the other of the adjacent two first support rods (220) and a corresponding at least one first guide bend portion (223) of the one of the adjacent two first support rods (220) abut against each other.

8. The support apparatus (22, 22a, 22b) according to claim 6, wherein the first stop portion (224) extends from the at least one first guide bend portion (223) along an axial direction of the first curved surface (2230) towards the at least one second guide bend portion (225) on a same side of the first rod body (221) as the first stop portion (224); the second stop portion (227) protrudes from an end of the second curved surface (2250) of the at least one second guide bend portion (225) close to the at least one first guide bend portion (223) on a same side of the first rod body (221) as the second stop portion (227).

9. The support apparatus (22, 22a, 22b) according to claim 2, wherein a plane where axis lines of two of the first curved surfaces (2230) on the two opposite sides of the first support rod (220) lie is coplanar with a front surface of the first rod body (221); or, a plane where axis lines of two of the second curved surfaces (2250) on the two opposite sides of the first support rod (220) lie is coplanar with a front surface of the first rod body (221).

10. The support apparatus (22, 22a, 22b) according to claim 2, wherein on each of the two opposite sides of each first support rod (220), the at least one first guide bend portion (223) comprises two first guide bend portions (223) and the at least one second guide bend portion (225) comprises two second guide bend portions (225); the two first guide bend portions (223) are arranged at two opposite ends of the first rod body (221) along a length direction of the first rod body (221), and the two second guide bend portions (225) are arranged at the two opposite ends of the first rod body (221) along the length direction of the first rod body (221); on each of the two opposite ends of the first rod body (221), a corresponding one of the two first guide bend portions (223) directly faces a corresponding one of the two second guide bend portions (225); axis lines of two of the first curved surfaces (2230) and axis lines of two of the second curved surfaces (2250) on a same side of the first support rod (220) are co-linear.

11. The support apparatus (22, 22a, 22b) according to any one of claims 1-10, wherein the first support rod (220) further comprises a connecting portion (226) connected to a back surface of the first rod body (221), and a support portion (228) connected to an end of the connecting portion (226) away from the at least one first guide bend portion (223); the support portion (228), the connecting portion (226), and the first rod body (221) encloses to define a sliding guide space (2282).

12. The support apparatus (22, 22a, 22b) according to any one of claims 1-10, wherein along a length direction of the first rod body (221), a stop portion (2218) is arranged on each of two opposite ends of a front surface of the first rod body (221), and a space between two of the stop portions (2218) on the opposite ends is configured to receive a flexible screen (50).

13. The support apparatus (22b) according to any one of claims 1-10, wherein the support apparatus (22b) further comprises a second support rod (220a) and a third support rod (220b); the second support rod (220a) is connected to one of two outermost first support rods (220) among the plurality of first support rods (220); the second support rod (220a) is rotatably connected to the one of two outermost first support rods (220) by a cooperation of the at least one first guide bend portion (223) and the at least one second guide bend portion (225); the third support rod (220b) is connected to the other of two outermost first support rods (220), among the plurality of first support rods (220), away from the second support rod (220a); the third support rod (220b) is rotatably connected to the other of two outermost first support rods (220) by a cooperation of the at least one first guide bend portion (223) and the at least one second guide bend portion (225).

14. A housing assembly (20), comprising the support apparatus (22, 22a, 22b) according to any one of claims 1-13, a first housing (24), and a second housing (26); wherein the first housing (24) is slidably connected to the second housing (26), and the support apparatus (22, 22a, 22b) is slidably wound around the second housing (26); a side of the support apparatus (22, 22a, 22b) is fixedly connected to the first housing (24); in a case where the first housing (24) slides relative to the second housing (26), the support apparatus (22, 22a, 22b) slides and rolls around the second housing (26).

15. An electronic device (100), comprising the housing assembly (20) according to claim 14 and a flexible screen (50); wherein the flexible screen (50) comprises a fixed area (52) and a sliding and rolling area (54); the fixed area (52) is fixed to the first housing (24) of the housing assembly (20), and the sliding and rolling area (54) is affixed to a front surface of the support apparatus (22, 22a, 22b) of the housing assembly (20).

## Patentansprüche

1. Stützeinrichtung (22, 22a, 22b), die eine Vielzahl erster Stützstangen (220) umfasst, die entlang einer ersten Richtung drehbar miteinander verbunden sind; wobei jede der Vielzahl von ersten Stützstangen (220) einen ersten Stangenkörper (221), mindestens einen ersten Führungsbogenabschnitt (223) und mindestens einen zweiten Führungsbogenabschnitt (225) umfasst; der erste Stangenkörper (221) zwei entlang der ersten Richtung gegenüberliegende Seiten aufweist, **dadurch gekennzeichnet, dass**
jede der beiden gegenüberliegenden Seiten des ersten Stangenkörpers (221) mit dem mindestens einen ersten Führungsbogenabschnitt (223) und dem mindestens einen zweiten Führungsbogenabschnitt (225) angeordnet ist; bei jeweils zwei benachbarten ersten Stützstangen (220) der Vielzahl von ersten Stützstangen (220) der mindestens eine erste Führungsbogenabschnitt (223) auf einer ersten Seite einer der beiden benachbarten ersten Stützstangen (220) drehbar an dem mindestens einen zweiten Führungsbogenabschnitt (225) auf einer zweiten Seite der anderen der beiden benachbarten ersten Stützstangen (220) anliegt, und der mindestens eine zweite Führungsbogenabschnitt (225) auf der ersten Seite der einen der beiden benachbarten ersten Stützstangen (220) drehbar an dem mindestens einen ersten Führungsbogenabschnitt (223) auf der zweiten Seite der anderen der beiden benachbarten ersten Stützstangen (220) anliegt.

2. Stützeinrichtung (22, 22a, 22b) nach Anspruch 1, wobei der mindestens eine erste Führungsbogenabschnitt (223) eine erste gekrümmte Oberfläche (2230) aufweist, der mindestens eine zweite Führungsbogenabschnitt (225) eine zweite gekrümmte Oberfläche (2250) aufweist und die erste gekrümmte Oberfläche (2230) und die zweite gekrümmte Oberfläche (2250) auf einer gleichen Seite jeder ersten Stützstange (220) eine Koaxiallinie aufweisen; die erste gekrümmte Oberfläche (2230) auf der ersten Seite einer der beiden benachbarten ersten Stützstangen (220) drehbar an der zweiten gekrümmten Oberfläche (2250) auf der zweiten Seite der anderen der beiden benachbarten ersten Stützstangen (220) anliegt, und die zweite gekrümmte Oberfläche (2250) auf der ersten Seite einer der beiden benachbarten ersten Stützstangen (220) drehbar an der ersten gekrümmten Oberfläche (2230) auf der zweiten Seite der anderen der beiden benachbarten ersten Stützstangen (220) anliegt.

3. Stützeinrichtung (22, 22a, 22b) nach Anspruch 1, wobei der mindestens eine erste Führungsbogenabschnitt (223) und der mindestens eine zweite Führungsbogenabschnitt (225) auf einer gleichen Seite jeder ersten Stützstange (220) entlang einer Längsrichtung des ersten Stangenkörpers (221) der ersten Stützstange (220) beabstandet sind; der mindestens eine erste Führungsbogenabschnitt (223) auf einer der beiden gegenüberliegenden Seiten der ersten Stützstange (220) dem mindestens einen zweiten Führungsbogenabschnitt (225) auf der anderen der beiden gegenüberliegenden Seiten der ersten Stützstange (220) entlang der ersten Richtung zugewandt ist, wobei die Längsrichtung des ersten Stangenkörpers (221) senkrecht zur ersten Richtung verläuft.

4. Stützeinrichtung (22, 22a, 22b) nach Anspruch 2, wobei der mindestens eine erste Führungsbogenabschnitt (223) ferner einen ersten gekrümmten Streifen auf einer Rückseite des ersten Stangenkörpers (221) aufweist und der mindestens eine zweite Führungsbogenabschnitt (225) ferner einen zweiten gekrümmten Streifen auf einer Rückseite des ersten Stangenkörpers (221) aufweist; die erste gekrümmte Oberfläche (2230) auf einer dem ersten gekrümmten Streifen zugewandten Oberfläche des ersten Stangenkörpers (221) angeordnet ist, und die zweite gekrümmte Oberfläche (2250) auf einer vom ersten Stangenkörper (221) abgewandten Oberfläche des zweiten gekrümmten Streifens angeordnet ist.

5. Stützeinrichtung (22, 22a, 22b) nach Anspruch 2, wobei die erste Stützstange (220) ferner einen ersten Anschlagabschnitt (224), der mit dem mindestens einen ersten Führungsbogenabschnitt (223) verbunden ist, und einen zweiten Anschlagabschnitt (227), der mit dem mindestens einen zweiten Führungsbogenabschnitt (225) verbunden ist, umfasst;
in einem Fall, dass die beiden benachbarten ersten Stützstangen (220) abgeflacht sind, der erste Anschlagabschnitt (224) einer der beiden benachbarten ersten Stützstangen (220) und der zweite Anschlagabschnitt (227) der anderen der beiden benachbarten ersten Stützstangen (220) aneinander anliegen;
in einem Fall, dass die beiden benachbarten ersten Stützstangen (220) relativ zueinander gebogen sind, der erste Anschlagabschnitt (224) einer der beiden benachbarten ersten Stützstangen (220) und der zweite Anschlagabschnitt (227) der anderen der beiden benachbarten ersten Stützstangen (220) sich voneinander entfernen.

6. Stützeinrichtung (22, 22a, 22b) nach Anspruch 5, wobei der erste Anschlagabschnitt (224) an einem Ende des mindestens einen ersten Führungsbogenabschnitts (223) vom ersten Stangenkörper (221) abgewandt ist, der zweite Anschlagabschnitt (227) an einem Ende des mindestens einen zweiten Führungsbogenabschnitts (225) vom ersten Stangenkörper (221) abgewandt ist und der erste Anschlagabschnitt (224) auf einer Seite des ersten Stangenkörpers (221) dem zweiten Anschlagabschnitt (227) auf einer gegenüberliegenden Seite des ersten Stangenkörpers (221) in der ersten Richtung direkt zugewandt ist.

7. Stützeinrichtung (22, 22a, 22b) nach Anspruch 6, wobei der erste Anschlagabschnitt (224) an der Seite des ersten Stangenkörpers (221) eine erste Anschlagfläche (2241), die dem zweiten Anschlagabschnitt (227) auf der gegenüberliegenden Seite des ersten Stangenkörpers (221) zugewandt ist, und eine zweite Anschlagfläche (2243), die dem ersten Stangenkörper (221) zugewandt ist, umfasst; der zweite Anschlagabschnitt (227) an der Seite des ersten Stangenkörpers (221) eine dritte Anschlagfläche (2271), die dem ersten Anschlagabschnitt (224) auf der gegenüberliegenden Seite des ersten Stangenkörpers (221) zugewandt ist, und eine vierte Anschlagfläche (2273), die dem ersten Anschlagabschnitt (224) entlang einer Längsrichtung des ersten Stangenkörpers (221) zugewandt ist, umfasst;
wobei in einem Fall, dass die beiden benachbarten ersten Stützstangen (220) abgeflacht sind, die erste Anschlagfläche (2241) einer der beiden benachbarten ersten Stützstangen (220) und die dritte Anschlagfläche (2271) der anderen der beiden benachbarten ersten Stützstangen (220) aneinander anliegen, die zweite Anschlagfläche (2243) der einen der beiden benachbarten ersten Stützstangen (220) und eine entsprechende zweite gekrümmte Oberfläche (2250) der anderen der beiden benachbarten ersten Stützstangen (220) aneinander anliegen, und die vierte Anschlagfläche (2273) der anderen der beiden benachbarten ersten Stützstangen (220) und mindestens ein entsprechender erster Führungsbogenabschnitt (223) der einen der beiden benachbarten ersten Stützstangen (220) aneinander anliegen.

8. Stützeinrichtung (22, 22a, 22b) nach Anspruch 6, wobei sich der erste Anschlagabschnitt (224) von dem mindestens einen ersten Führungsbogenabschnitt (223) entlang einer Axialrichtung der ersten gekrümmten Oberfläche (2230) zu dem mindestens einen zweiten Führungsbogenabschnitt (225) auf einer gleichen Seite des ersten Stangenkörpers (221) wie der erste Anschlagabschnitt (224) erstreckt; der zweite Anschlagabschnitt (227) von einem Ende der zweiten gekrümmten Oberfläche (2250) des mindestens einen zweiten Führungsbogenabschnitts (225) nahe dem mindestens einen ersten Führungsbogenabschnitt (223) auf einer gleichen Seite des ersten Stangenkörpers (221) wie der zweite Anschlagabschnitt (227) hervorsteht.

9. Stützeinrichtung (22, 22a, 22b) nach Anspruch 2, wobei eine Ebene, in der die Achsenlinien zweier der ersten gekrümmten Oberflächen (2230) auf den beiden gegenüberliegenden Seiten der ersten Stützstange (220) liegen, mit einer Vorderseite des ersten Stangenkörpers (221) komplanar ist; oder eine Ebene, in der die Achsenlinien zweier der zweiten gekrümmten Oberflächen (2250) auf den beiden gegenüberliegenden Seiten der ersten Stützstange (220) liegen, mit einer Vorderseite des ersten Stangenkörpers (221) komplanar ist.

10. Stützeinrichtung (22, 22a, 22b) nach Anspruch 2, wobei auf jeder der beiden gegenüberliegenden Seiten jeder ersten Stützstange (220) der mindestens eine erste Führungsbogenabschnitt (223) zwei erste Führungsbogenabschnitte (223) umfasst und der mindestens eine zweite Führungsbogenabschnitt (225) zwei zweite Führungsbogenabschnitte (225) umfasst; die beiden ersten Führungsbogenabschnitte (223) an zwei gegenüberliegenden Enden des ersten Stangenkörpers (221) entlang einer Längsrichtung des ersten Stangenkörpers (221) angeordnet sind, und die beiden zweiten Führungsbogenabschnitte (225) an zwei gegenüberliegenden Enden des ersten Stangenkörpers (221) entlang der Längsrichtung des ersten Stangenkörpers (221) angeordnet sind; an jedem der beiden gegenüberliegenden Enden des ersten Stangenkörpers (221) jeweils ein entsprechender der beiden ersten Führungsbogenabschnitte (223) direkt einem entsprechenden der beiden zweiten Führungsbogenabschnitte (225) zugewandt ist; Achsenlinien zweier der ersten gekrümmten Oberflächen (2230) und Achsenlinien zweier der zweiten gekrümmten Oberflächen (2250) auf einer gleichen Seite der ersten Stützstange (220) kollinear sind.

11. Stützeinrichtung (22, 22a, 22b) nach einem der Ansprüche 1-10, wobei die erste Stützstange (220) ferner einen Verbindungsabschnitt (226), der mit einer Rückseite des ersten Stangenkörpers (221) verbunden ist, und einen Stützabschnitt (228), der mit einem Ende des Verbindungsabschnitts (226) verbunden ist, das von dem mindestens einen ersten Führungsbogenabschnitt (223) abgewandt ist, umfasst; der Stützabschnitt (228), der Verbindungsabschnitt (226) und der erste Stangenkörper (221) sich zusammenfügen, um einen verschiebbaren Führungsraum (2282) zu definieren.

12. Stützeinrichtung (22, 22a, 22b) nach einem der Ansprüche 1-10, wobei entlang einer Längsrichtung des ersten Stangenkörpers (221) an jedem von zwei gegenüberliegenden Enden einer Vorderseite des ersten Stangenkörpers (221) ein Anschlagabschnitt (2218) angeordnet ist und ein Raum zwischen zwei der Anschlagabschnitte (2218) an den gegenüberliegenden Enden dazu konfiguriert ist, einen flexiblen Bildschirm (50) aufzunehmen.

13. Stützeinrichtung (22b) nach einem der Ansprüche 1-10, wobei die Stützeinrichtung (22b) ferner eine zweite Stützstange (220a) und eine dritte Stützstange (220b) umfasst; die zweite Stützstange (220a) mit einer von zwei äußersten ersten Stützstangen (220) unter der Vielzahl von ersten Stützstangen (220) verbunden ist; die zweite Stützstange (220a) drehbar mit der einen von zwei äußersten ersten Stützstangen (220) durch ein Zusammenwirken des mindestens einen ersten Führungsbogenabschnitts (223) und des mindestens einen zweiten Führungsbogenabschnitts (225) verbunden ist; die dritte Stützstange (220b) mit der anderen von zwei äußersten ersten Stützstangen (220) unter der Vielzahl von ersten Stützstangen (220), fern von der zweiten Stützstange (220a) verbunden ist; die dritte Stützstange (220b) drehbar mit der anderen von zwei äußersten ersten Stützstangen (220) durch ein Zusammenwirken des mindestens einen ersten Führungsbogenabschnitts (223) und des mindestens einen zweiten Führungsbogenabschnitts (225) verbunden ist.

14. Gehäuseanordnung (20), umfassend die Stützeinrichtung (22, 22a, 22b) nach einem der Ansprüche 1-13, ein erstes Gehäuse (24) und ein zweites Gehäuse (26); wobei das erste Gehäuse (24) verschiebbar mit dem zweiten Gehäuse (26) verbunden ist und die Stützeinrichtung (22, 22a, 22b) verschiebbar um das zweite Gehäuse (26) gewickelt ist; eine Seite der Stützeinrichtung (22, 22a, 22b) fest mit dem ersten Gehäuse (24) verbunden ist; in einem Fall, dass das erste Gehäuse (24) relativ zum zweiten Gehäuse (26) gleitet, die Stützeinrichtung (22, 22a, 22b) um das zweite Gehäuse (26) gleitet und rollt.

15. Elektronische Vorrichtung (100), umfassend die Gehäuseanordnung (20) nach Anspruch 14 und einen flexiblen Bildschirm (50); wobei der flexible Bildschirm (50) einen festen Bereich (52) und einen gleitfähigen und rollbaren Bereich (54) umfasst; der feste Bereich (52) am ersten Gehäuse (24) der Gehäuseanordnung (20) befestigt ist, und der gleitfähige und rollbare Bereich (54) an einer Vorderseite der Stützeinrichtung (22, 22a, 22b) der Gehäuseanordnung (20) angebracht ist.

## Revendications

1. Appareil de support (22, 22a, 22b) comprenant une pluralité de premières tiges de support (220) qui sont reliées les unes aux autres de manière rotative dans une première direction ; dans lequel chacune de la pluralité de premières tiges de support (220) comprend un corps de première tige (221), au moins une première portion de coude de guidage (223) et au moins une seconde portion de coude de guidage (225) ; le corps de première tige (221) présentant deux côtés opposés dans la première direction, **caractérisé en ce que** :
chacun des deux côtés opposés du corps de première tige (221) est agencé avec la au moins une première portion de coude de guidage (223) et la au moins une seconde portion de coude de guidage (225) ; pour chaque paire de premières tiges de support adjacentes (220) de la pluralité de premières tiges de support (220), la au moins une première portion de coude de guidage (223) d'un premier côté d'une certaine des deux premières tiges de support adjacentes (220) vient en butée de manière rotative contre la au moins une seconde portion de coude de guidage (225) d'un second côté de l'autre des deux premières tiges de support adjacentes (220), et la au moins une seconde portion de coude de guidage (225) du premier côté de la certaine des deux premières tiges de support adjacentes (220) vient en butée de manière rotative contre au moins une première portion de coude de guidage (223) du seconde côté de l'autre des deux premières tiges de support adjacentes (220).

2. Appareil de support (22, 22a, 22b) selon la revendication 1, dans lequel la au moins une première portion de coude de guidage (223) comprend une première surface incurvée (2230), la au moins une seconde portion de coude de guidage (225) comprend une seconde surface incurvée (2250), et la première surface incurvée (2230) et la seconde surface incurvée (2250) d'un même côté de chaque première tige de support (220) présentent une ligne coaxiale ; la première surface incurvée (2230) du premier côté d'une certaine des deux premières tiges de support adjacentes (220) vient en butée de manière rotative contre la seconde surface incurvée (2250) du second côté de l'autre des deux premières tiges de support adjacentes (220), et la seconde surface incurvée (2250) du premier côté d'une certaine des deux premières tiges de support adjacentes (220) vient en butée de manière rotative contre la première surface incurvée (2230) du second côté de l'autre des deux premières tiges de support adjacentes (220).

3. Appareil de support (22, 22a, 22b) selon la revendication 1, dans lequel la au moins une première portion de coude de guidage (223) et la au moins une seconde portion de coude de guidage (225) d'un même côté de chaque première tige de support (220) sont espacées dans une direction de longueur du corps de première tige (221) de la première tige de support (220) ; la au moins une première portion de coude de guidage (223) d'un certain des deux côtés opposés de la première tige de support (220) fait face à la au moins une seconde portion de coude de guidage (225) de l'autre des deux côtés opposés de la première tige de support (220) dans la première direction, la direction de longueur du corps de première tige (221) étant perpendiculaire à la première direction.

4. Appareil de support (22, 22a, 22b) selon la revendication 2, dans lequel la au moins une première portion de coude de guidage (223) comprend en outre une première bande incurvée disposée sur une surface arrière du corps de première tige (221), et la au moins une seconde portion de coude de guidage (225) comprend en outre une seconde bande incurvée agencée sur une surface arrière du corps de première tige (221) ; la première surface incurvée (2230) est agencée sur une surface du corps de première tige (221) faisant face à la première bande incurvée, et la seconde surface incurvée (2250) est agencée sur une surface de la seconde bande incurvée opposée au corps de première tige (221).

5. Appareil de support (22, 22a, 22b) selon la revendication 2, dans lequel la première tige de support (220) comprend en outre une première portion d'arrêt (224) reliée à la au moins une première portion de coude de guidage (223) et une seconde portion d'arrêt (227) reliée à la au moins une seconde portion de coude de guidage (225) ;
dans un cas dans lequel les deux premières tiges de support adjacentes (220) sont aplaties, la première portion d'arrêt (224) d'une certaine des deux premières tiges de support adjacentes (220) et la seconde portion d'arrêt (227) de l'autre des deux premières tiges de support adjacentes (220) viennent en butée l'une contre l'autre ;
dans un cas dans lequel les deux premières tiges de support adjacentes (220) sont courbées l'une par rapport à l'autre, la première portion d'arrêt (224) d'une certaine des deux premières tiges de support adjacentes (220) et la seconde portion d'arrêt (227) de l'autre des deux premières tiges de support adjacentes (220) s'éloignent l'une de l'autre.

6. Appareil de support (22, 22a, 22b) selon la revendication 5, dans lequel la première portion d'arrêt (224) est agencée sur une extrémité de la au moins une première portion de coude de guidage (223) éloignée du corps de première tige (221), la seconde portion d'arrêt (227) est agencée sur une extrémité de la au moins une seconde portion de coude de guidage (225) éloignée du corps de première tige (221), et la première portion d'arrêt (224) d'un côté du corps de première tige (221) fait directement face à la seconde portion d'arrêt (227) du côté opposé du corps de première tige (221) dans la première direction.

7. Appareil de support (22, 22a, 22b) selon la revendication 6, dans lequel la première portion d'arrêt (224) du côté du corps de première tige (221) comprend une première surface d'arrêt (2241) faisant face à la seconde portion d'arrêt (227) du côté opposé du corps de première tige (221), et une deuxième surface d'arrêt (2243) faisant face au corps de première tige (221) ; la seconde portion d'arrêt (227) du côté du corps de première tige (221) comprend une troisième surface d'arrêt (2271) faisant face à la première portion d'arrêt (224) du côté opposé du corps de première tige (221), et une quatrième surface d'arrêt (2273) faisant face à la première portion d'arrêt (224) dans la direction de longueur du corps de première tige (221) ;
dans un cas dans lequel les deux premières tiges de support adjacentes (220) sont aplaties, la première surface d'arrêt (2241) d'une certaine des deux premières tiges de support adjacentes (220) et la troisième surface d'arrêt (2271) de l'autre des deux premières tiges de support adjacentes (220) viennent en butée l'une contre l'autre, la deuxième surface d'arrêt (2243) de la certaine des deux premières tiges de support adjacentes (220) et une seconde surface incurvée correspondante (2250) de l'autre des deux premières tiges de support adjacentes (220) viennent en butée l'une contre l'autre, et la quatrième surface d'arrêt (2273) de l'autre des deux premières tiges de support adjacentes (220) et au moins une première portion de coude de guidage correspondante (223) de la certaine des deux premières tiges de support adjacentes (220) viennent en butée l'une contre l'autre.

8. Appareil de support (22, 22a, 22b) selon la revendication 6, dans lequel la première portion d'arrêt (224) s'étend depuis la au moins une première portion de coude de guidage (223) dans une direction axiale de la première surface incurvée (2230) vers la au moins une seconde portion de coude de guidage (225) d'un même côté du corps de première tige (221) que la première portion d'arrêt (224) ; la seconde portion d'arrêt (227) fait saillie depuis une extrémité de la deuxième surface incurvée (2250) de la au moins une seconde partie de coude de guidage (225) près de la au moins une première partie de coude de guidage (223) d'un même côté du corps de première tige (221) que la seconde portion d'arrêt (227).

9. Appareil de support (22, 22a, 22b) selon la revendication 2, dans lequel un plan dans lequel se trouvent des lignes d'axe de deux des premières surfaces incurvées (2230) sur les deux côtés opposés de la première tige de support (220) est coplanaire avec une surface avant du corps de première tige (221) ; ou, un plan dans lequel se trouvent des lignes d'axe de deux des secondes surfaces incurvées (2250) sur les deux côtés opposés de la première tige de support (220) est coplanaire avec une surface avant du corps de première tige (221).

10. Appareil de support (22, 22a, 22b) selon la revendication 2, dans lequel sur chacun de deux côtés opposés de chaque première tige de support (220), la au moins une première portion de coude de guidage (223) comprend deux portions de coude de guidage (223) et la au moins une seconde portion de coude de guidage (225) comprend deux secondes portions de coude de guidage (225) ; les deux premières portions de coude de guidage (223) sont agencées aux deux extrémités opposées du corps de première tige (221) dans une direction de longueur du corps de première tige (221), et les deux secondes portions de coude de guidage (225) sont agencées aux deux extrémités opposées du corps de première tige (221) dans la direction de longueur du corps de première tige (221) ; à chacune des deux extrémités opposées du corps de première tige (221), une certaine correspondante des deux premières portions de coude de guidage (223) fait face directement à une certaine correspondante des deux secondes portions de coude de guidage (225) ; des lignes d'axe de deux des premières surfaces incurvées (2230) et des lignes d'axe de deux des secondes surfaces incurvées (2250) d'un même côté de la première tige de support (220) sont colinéaires.

11. Appareil de support (22, 22a, 22b) selon l'une quelconque des revendications 1-10, dans lequel la première tige de support (220) comprend en outre une portion de connexion (226) reliée à une surface arrière du corps de première tige (221), et une portion de support (228) reliée à une extrémité de la portion de connexion (226) éloignée de la au moins une première portion de coude de guidage (223) ; la portion de support (228), la portion de connexion (226) et le corps de première tige (221) se ferment pour définir un espace de guidage coulissant (2282).

12. Appareil de support (22, 22a, 22b) selon l'une quelconque des revendications 1-10, dans lequel dans une direction de longueur du corps de première tige (221), une portion d'arrêt (2218) est agencée sur chacune de deux extrémités opposées d'une surface avant du corps de première tige (221), et un espace entre deux des parties d'arrêt (2218) sur les extrémités opposées est configuré pour recevoir un écran flexible (50).

13. Appareil de support (22b) selon l'une quelconque des revendications 1-10, dans lequel l'appareil de support (22b) comprend en outre une deuxième tige de support (220a) et une troisième tige de support (220b) ; la deuxième tige de support (220a) est reliée à une certaine des deux premières tiges de support les plus extérieures (220) parmi la pluralité de premières tiges de support (220) ; la deuxième tige de support (220a) est reliée de manière rotative à la certaine des deux premières tiges de support les plus extérieures (220) par une coopération de la au moins une première portion de coude de guidage (223) et de la au moins une seconde portion de coude de guidage (225) ; la troisième tige de support (220b) est reliée à l'autre des deux premières tiges de support les plus extérieures (220) parmi la pluralité de premières tiges de support (220), à l'opposé de la deuxième tige de support (220a) ; la troisième tige de support (220b) est reliée de manière rotative à l'autre des deux premières tiges de support les plus extérieures (220) par une coopération de la au moins une première portion de coude de guidage (223) et de la au moins une seconde portion de coude de guidage (225).

14. Ensemble de boîtiers (20), comprenant l'appareil de support (22, 22a, 22b) selon l'une quelconque des revendications 1-13, un premier boîtier (24) et un second boîtier (26) ; dans lequel le premier boîtier (24) est relié de manière coulissante au second boîtier (26), et l'appareil de support (22, 22a, 22b) est enroulé de manière coulissante autour du second boîtier (26) ; un côté de l'appareil de support (22, 22a, 22b) est relié de manière fixe au premier boîtier (24) ; dans un cas dans lequel le premier boîtier (24) coulisse par rapport au second boîtier (26), l'appareil de support (22, 22a, 22b) coulisse et roule autour du seconde boîtier (26).

15. Dispositif électronique (100), comprenant l'ensemble de boîtiers (20) selon la revendication 14 et un écran flexible (50) ; dans lequel l'écran flexible (50) comprend une zone fixe (52) et une zone de coulissement et de roulement (54) ; la zone fixe (52) est fixée au premier boîtier (24) de l'ensemble de boîtiers (20), et la zone de coulissement et de roulement (54) est fixée à une surface avant de l'appareil de support (22, 22a, 22b) de l'ensemble de boîtiers (20).
